Europäisches Patentamt

European Patent Office

Office européen des brevets

(19)

(11) Publication number: **0 352 194**
A1

# EUROPEAN PATENT APPLICATION

(12)

(21) Application number: 89402076.7

(22) Date of filing: 21.07.89

(51) Int. Cl.5: **G 11 B 11/00**
G 11 B 9/00, G 11 B 11/12

(30) Priority: 22.07.88 FR 8809916
17.02.89 FR 8902105
17.02.89 FR 8902106

(43) Date of publication of application:
24.01.90 Bulletin 90/04

(84) Designated Contracting States:
BE CH DE ES FR GB IT LI NL SE

(71) Applicant: SCHLUMBERGER INDUSTRIES
50, avenue Jean Jaurès
F-92120 Montrouge (FR)

(72) Inventor: Meyrueix, Paul
808 Saratoga Avenue Oakwood Apt 0111
San Jose CA 95129 (US)

(74) Representative: Monod, Jean-Yves
SCHLUMBERGER INDUSTRIES CENTRE DE
RECHERCHE/SMR B.P. 620-05
F-92542 Montrouge Cédèx (FR)

(54) Methods, apparatus and media for recording information.

(57) Method and apparatus for recording information on a recording media (415) comprising a polymer material including electrooptically active molecules (415). The electrooptical properties of the material are modified at selected locations (416 and 417) of the media in correspondance of the information to be recorded. The recorded information can be read by detecting variations in the electrooptical properties of the polymer material across the media (411).

FIG.14

EP 0 352 194 A1

## Description

## METHODS, APPARATUS AND MEDIA FOR RECORDING INFORMATION

This invention relates to new media, methods and apparatus for recording and reproducing information, which may be of a binary, analog or pseudo analog type, or vector type, e.g. involving both modules and direction parameters. It is based on the observation of the properties of certain electro-optical polymer materials.

The existence has long been known of crystals of which the optical properties can be modified so as to display anisotropy in the presence of an electric field. These materials are gathered together as a rule under the name of non-linear optical materials. In practice, the anisotropy produced in such materials in the presence of an electric field manifests itself by the change in the refractive index of the material in at least one direction. Conventionally, two types of effect are distinguished in that respect. In the first, the phase lag created between the components of the electric field along two axes of an incident beam of light polarised in accordance with the electric field to which the material is subjected, varies in a linear relationship with the intensity of the field. This effect is called the Pockels effect. In the other type of effect, the phase lag varies as the square of the intensity of the electric field. This effect is known as the Kerr effect.

Different kinds of material are capable of providing crystals exhibiting the properties above-mentioned. However, these crystals are not always easy to use or may only be available in relatively small size. Now for some time, the appearance has been noted of electro-optical materials enabling these difficulties to be surmounted: in these materials, the electro-optically active molecules are organic molecules. These molecules can be used in films, fibres, thin or thick layers whether deposited on substrates or not. In particular, there exist polymers in which the electro-optically-active molecules are incorporated in suitable proportions in a matrix of a base material itself devoid of such properties.

In practice, in the absence of any special conditions, such materials are amorphous and present no electro-optical effect. No change in refractive index can be observed when an electric field is applied within these materials. It has been found, however, in accordance with the development leading to the invention, that when the electrooptically active molecules are oriented in a preferential direction an optical anisotropy may be observed in the presence of an electrical field. Such an orientation of the electrooptically active molecules may be achieved by subjecting these molecules to an electric field under certain conditions.

It has been further found that with some currently existing polymer materials, the material must be first heated above a transitional temperature before the electrooptically active molecules may acquire sufficient mobility to allow their orientation to be changed under the action of an electric field. Once the material has been so heated, the electrooptically active molecules tend to take an orientation in the direction of the applied electric field (affecting therefore the directional characteristics of the resulting optical anisotropy) ; in addition the intensity of this electric field also alters the level of observable electrooptical activity of the material. It has been further determined that if the material is allowed to return below the transitional temperature while such orienting electric field is applied thereto, the electrooptically active molecules are fixed again within the matrix thereby keeping in the material an image, in the direction and intensity, of the electric field which originated such an orientation.

One object of the invention is to use these findings to record information on media comprising such polymer materials.

Accordingly, the invention relates to a method for recording information on a recording media comprising a polymer material including electrooptically active molecules wherein the electrooptical properties of the polymer material are modified at selected locations of the media in correspondence with the information to be recorded, whereby such recorded information can be read by detecting variations in the electrooptical properties of the polymer material across at least one dimension of the media.

The polymer material which forms the active portion of the media may comprise a matrix of a chemical compound which is not electrooptically active and within the bonds of which are trapped molecules of a dopant having electrooptical activity. Such media may typically comprise a film of such a polymer material and the electrooptical properties may be modified along at least one dimension parallel to the surface of such film in accordance with the information to be recorded.

According to one embodiment of the invention, it is also envisioned that the electrooptical properties of the polymer material may be modified in a direction which is transverse to the surface of the media. Accordingly, if these properties are also modulated along two dimensions parallel to the surface of such media, a three dimensional or volumic recording may be achieved.

A recording obtained in accordance with the invention may be read by interrogating the media with a beam of light which is then analyzed after it has interfered with the polymer material while this material is subjected to an electric field. Such analysis indicates which locations of the media exhibit a level of electrooptical activity (such level being variable, in certain cases) and which do not.

It will be immediately seen that this method therefore affords a non contact technique for recording and /or reading a record. In addition, the method allows to modify the electrooptical properties of the polymer material at selected locations of very minute dimensions, hence affording the possibility of making very high density recordings.

The specific method for reading the records obtained in accordance with the invention will be discussed in more detail later on.

In accordance with one embodiment, the recording of the information is carried out by acting on the orientation of the electrooptically active molecules of the polymer material at selective locations of the media.

In an implementation of this method the temperature is raised in at least one zone of the polymer material above a transitional level beyond which the orientation of the molecules having electro-optical activity can be modified by external action; in that zone an electric field is applied of which the direction and/or intensity are determined in keeping with the optical-anisotropy characteristics of the material it is desired to obtain ; and during the application of that field, the temperature is reduced in that zone below the transitional temperature in order to fix the characteristics of the field applied in the material. Frequent reference will be made to that electric field as the orienting, writing or polarising field.

The intensity of the electric field applied to the material may be modulated in at least one direction in space in such a way as to cause variation in one optical-anisotropy characteristic of that material along that direction. For this purpose, relative travel can, in particular be caused to occur along that direction, between the material and the source of the electric field. The modulation of the electric field is produced by a signal or data to be recorded. The resulting variations in the optical-anisotropy characteristic in the material along that direction constitute a recording of that signal or of those data in accordance with a parameter which may be represented by the variation in distances in that direction.

To read such a recording, an electric field is necessary to reveal the variations in the aforementioned anisotropy characteristic of the material along the direction concerned. To achieve this, the material can be subjected to an electric field, hereinafter called the detecting, revealing or reading field. An optical detection device measures the variations in electro-optical activity of the material along the said direction in order to read the information or the signal which initially caused the modulation of the orienting electric field.

The variation of the optical-anisotropy characteristic in accordance with this method can be performed in several directions within the material. A multi-dimensional recording is thus obtained. It should be noted here that this technique enables the making, in each elementary zone or selected location of the polymer material, of either a binary, all-or-nothing type of recording, or a recording of a level proportional to the intensity of the orienting field. The latter type of recording may be obtained by varying within a certain range the intensity of the writing or polarizing electric field applied at the selected location of the polymer material while its temperature is above the transitional point, in accordance with the analog magnitude of a parameter to be recorded. Alternatively, the writing electric field may be caused to vary among a number of discrete values over said range in response to the parameter to be recorded, thus creating a pseudo analog recording. It will be apparent that the recordings thus obtained may be erased simply by subjecting all of the locations of the polymer material to a uniform electric field (which may be zero) after the temperature of the same has been elevated above the transitional level.

In the embodiment currently discussed, the recording in the material may be achieved according to two different methods. The first is to heat locally and apply a global electric field. The second is to heat globally and apply a local electric field.

In the second method aforesaid, the process enables data to be recorded of analogue or quasi-analogue type, by heating the material globally and by applying local electric fields of different values; those fields may be advantageously created by local deposition of charges or by subjecting the material to given potentials.

According to one mode of implementation the molecules of the material are globally pre-oriented beforehand, by simultaneous application of heat and of a given exciting electric field, with cooling under that field and then the material is subjected to the local application of heat under a null electric field. According to another mode, the molecules of the material are oriented locally by simultaneous local application of an exciting electric field and of heat to a polymer initially having its active molecules randomly oriented.

In the first case, the recording is tantamount to locally destroying the previous global orientation of the molecules of the material; in the second case, the recording is made in the material by locally orienting the molecules; the molecules of the dopant become oriented in the electric field and preserve their orientation as soon as the temperature of the material falls below the critical temperature necessary for orientation.

Using either of the two above-mentioned implementations, the material presents a succession of non-oriented and oriented zones, which constitute data in the form of two-state, 0 or 1 bits. A number of write/read cycles may be achieved.

A local electric field may be created by deposition of localised electric charges on the surface of the media when its temperature is raised above the transitional level. The media includes a first layer of an electrooptical polymer material and a second, transparent, layer of a photoconductive material, i.e. of which the conductivity increases as the illumination. One of the faces of the media bears a conducting, transparent film consituting an electrode connected to ground. Facing the transparent photoconductive layer and in contact with it, a transparent electrode is set up and connected to a potential v. Under illumination by a writing laser beam a conducting channel is created between the zone in the upper part of the photoconductive layer raised to potential v, and the zone in the upper part of the media where the controlling beam is focused ; the latter zone is then at potential v and accumulates electrical charges which are maintained locally on account of the non-conductivity of the polymer of which the media is made, by creating an electric field in the thickness of the media under the effect of which the electro-active molecules become oriented. The media temperature is raised at a higher level than the critical temperature Tc for a sufficient duration after the appearance of the potential v on the zone to be polarised for the orientation of the molecules to take place. The said orientation becomes fixed during the subsequent cooling of the media. This method of implementation exhibits the advantage of requiring a low-power laser emitter.

According to an additional aspect, a polymer material may be used that presents both electrical and photoconductive properties at the same time. The writing laser beam passing through the material creates a conducting well to the ground electrode nullifying the writing electric field.

According to yet another embodiment of the invention the information is recorded by modifying the chemical structure of the electrooptically molecules of the polymer material to irreversibly modify their electrooptical properties at the selected locations in correspondence with the information to be recorded. This modification may be a destruction of the electrooptically active molecules to cancel their electrooptical activity.

It is worthwhile to use for this purpose as a recording media an electro-optical polymer film of which the chemical structure in the zones to be written to is wholly or partly changed by external application of energy, e.g. heat, electricity or light. In the latter case, in particular, the recording may advantageously be performed by selectively illuminating the zones to be written-to with a light of a wavelength chosen so as to cause the breaking-up of the molecules possessing non-linear optical activity that are imprisoned in the film matrix. The recording is thus constituted by a pattern of electro-optically active and non-active zones distributed within the plane of the film. Each elementary writing zone can represent one bit of the recorded information.

If as a starting point the active molecules of the media were oriented and fixed in that state before the active molecules are destroyed in certain zones to make the recording, the reading of that recording is simply performed by lighting the media in the presence of a reading electric field.

The reading of a recording in accordance with the invention is based on the revealing of electro-optically active zones and non-active zones. The zones of the media which contain active molecules that are suitably oriented can alter certain properties of the light used to interrogate for reading purposes in the presence of an electric field, while the zones that do not contain such molecules are without effect on those properties.

Thus, if a beam of polarised light is used to interrogate the recording, the state of polarisation of the light is altered by the active, oriented molecules to an extent which depends on the intensity of the electric field to which those molecules are subjected. By suitably routing the beam resulting from the interaction of the incident light with the material, conventional means can be used to determine any changes in the state of polarisation according to the constitution of the zones of the media struck by the incident light. The recording as a whole is read by causing relative travel or scanning of the recording media with respect to the reading apparatus. As in the first embodiment, an interferometry technique may be also used.

In both embodiments, the writing and reading stages can be conducted with no contact with the film or tape, which eliminates problems of wear. Moreover, the cost of the media is small, since no deposition has to be carried out. In addition, reading is rendered more simple, since it is effected by the transmission of a beam of light - so that the evenness of the media is not a critical factor - and above all, because the electro-optical bi-refringence may be high, from ten to several tens of degrees. Reading may also be effected by reflection of light on one of the faces of the media, after transmission within the material. Furthermore, the density of information may be high, since first, bit size is dependent only upon the size of the zone subjected to the local field or locally heated, and secondly, the material is not a conductor.

Several additional features may be implemented with both embodiments. According to one of these features, when reading the recording, arrangements can be provided to modulate the exciting field, e.g. in amplitude, alternatingly. When the polymer material at the location in the media struck by the light used for reading contains active oriented molecules, the light that comes from it is also modulated in step with the field. The detection of this modulation, in line with the modulation of the exciting electric field, for example by the provision of a band pass filter, makes it easy to pinpoint the zones that are electro-optically active in the recording. The ability to do this constitutes an important advantage of the technique in accordance with the invention. Light losses due e.g. to a local defect on the material (dust), do not affect the detection of the signal, since detection is not based on the average level of the signal (which is very sensitive to the quantity of light) but on the differentiation between the constant signal and the modulated signal ; thus the only effect of any local defect on the recording media will be to diminish the average signal level at that point. Preferably, the frequency of modulation of the reading electric field will be appreciably greater than the frequency corresponding to the pace of recording/reading of the information on the recording media. Advantageously, the signal is modulated in such a way as to present a few periods of modulation for one elementary unit of information.

According to yet another feature applicable to both embodiments, the modulation of the anisotropy characteristics can be effected in several directions in space inside the material. A multi-dimensional recording is obtained. It is thus possible to write at different levels in the thickness of a sheet or tape recording media. This is because, by local heating or otherwise applying energy at each given level, under a given orienting field, a volume recording of information is made, along the three dimensions of the media.

Preferably, in accordance with this feature, in addition to locally applying energy to the material at a given depth, a plurality of electrodes pairs are provided in the thickness of the recording media, and each of them is capable of causing a local electric field to occur in a given layer of the polymer material corresponding to the given depth.

Advantageously the data-recording media may include, in the direction of its thickness, a succession of three-layer sandwiches, viz. a first, conducting layer (forming a first electrode), a second, electro-optical polymer layer (receiving the data), a third, conducting layer (forming a second electrode), each three-layer sandwich situated at a given depth in the media being separated from the next by an inactive separation layer.

According to the invention there is also provided apparatus for recording information on a recording media comprising a polymer material including electrooptically active molecules, comprising means for locally modifying the electrooptical properties of the polymer material at selected locations of said media and means for effecting relative displacement of said media and said modifying means in correspondence with information to be recorded. The relative displacement means may comprise means effective to displace the media past the modifying means as well as means for adjusting the depth of focus of said modifying means within the media for recording information along a dimension transverse to the surface of said media.

In one alternative, the modifying means are operative to affect the orientation of the electrooptically active molecules in the polymer. These modifying means may comprise means of providing local heating and means of generating an overall orienting electric field in which the data recording media can be placed.

As a variant, the aforesaid modifying means may include means of providing global heating and means of generating a local electric field in the media.

Advantageously, the means of local heating may include a emitter of a laser beam capable of being focused on the recording media. In this case, electrodes can be set up on either side of the media; the electrodes are constructed of a material that is both conducting and able to let the light from the laser beam pass through. The electrodes may, for instance, be composed of two plates with a potential difference between them, with the media travelling in their neighbourhood.

According to one variant, the means for generating the electric field are capable of depositing electrostatic charges on the surface of the media; for example, they can be constituted by a source of electrons.

In order to obtain a high density of data, the modifying means may be capable of creating several parallel tracks each carrying a series of successive bits. Where the means of providing the heating consist of lasers, it is advantageous for the device to have either one laser emitter per track, or a single emitter combined with means for controlling the direction of the laser beam emitted by the single emitter.

As a further alternative, the aforesaid modifying means comprise means for selectively applying energy to said polymer material for modifying the chemical structure thereof irreversibly to affect the electrooptical properties of the active molecules at selected locations of the media.

The data recording media comprising the polymer material with electro-optical properties, may be produced in the form of a film, cut for instance in such a way as to constitute a tape or disk.

The invention also concerns apparatus for reading the information recorded on the electro-optical media, comprising means for generating a reading electric field, means for generating a beam of light able to pass through the media, and means for optical analysis of the said beam as it leaves the media. Reading can be effected either by transmission of the light beam or by the latter's reflection.

Advantageously means are provided for modulating the reading electric field and said optical analysis means comprises means for detecting the corresponding modulation in the resulting light. The means for generating the reading light beam may be constituted by a laser-beam emitter.

The means for optical analysis are for example of polarimetric type, and include a combined polarising and analysing unit and a detector. As a variant, the aforesaid means of optical analysis may be of interferometric type.

In order to avoid mistaken alteration, on reading, of the orientation of the molecules, the laser emitter for reading may be of lower power than the laser emitter for writing (local heating).

Advantageously, the recording media is absorbent for the writing wavelength (in order to heat it as much as possible) and of low absorbency (translucent or transparent) for the reading wavelength (to allow good transmission of the reading light beam).

In order to free it from the consequences of time-drift in the read signals, the apparatus may include means for recording on the media reference data and means of comparison between the reference signals and the signals corresponding to information as such. These reference data are also designed to guide the reading means.

The invention also concerns a media for recording infomation, comprising a polymer material including electrooptically active molecules, whereby the information is recorded as a modulation of the electrooptical properties of the polymer material across at least one dimension of such media. The polymer material may comprise a matrix within the bonds of which are trapped electrooptically active molecules of a dopant. Several layers of polymer material may be provided. Each layer may be a sandwich between respective electrodes whereby an electric field may be applied in the respective polymer material layer. It may be advantageous in some cases to provide that the electrooptically active molecules of the unrecorded media to be preferentially oriented substantially in the same direction. Such direction may be non perpendicular to the surface of the media.

Returning to the embodiment wherein the electrooptical properties of the polymer material are irreversibly altered at selected locations, such technique and the systems for implementing it present advantages in terms of simplicity and robustness of implementation and of recording capacity.

The latter technique makes it possible, in particular, to make high-density recordings in a polymer film which can be produced in very large areas and at low cost. It therefore lends itself well to situations where a large number of data must be recorded, e.g. using lasers on mass-market media. These recordings can be obtained on terminals that are simple to operate, given that the resources necessary to write irreversibly can be produced with low-cost optical or electrical equipment, requiring a small quantity of energy to work them. This is particularly so when the destruction of the active molecules is opted-for, using laser light of an appropriate wavelength.

The technique is particularly suited to situations where the recording on a mass-market media is made at variable intervals and on terminals which may differ, depending on events determined by the bearer of the media. Such is in particular the case for media in the form of portable objects such as memory cards which are intended to be handled and carried individually by persons. Such media are currently used or being developed for numerous everyday applications, e.g. for making up portable individual medical records. During each use of the card in the terminal, supplementary information is recorded which completes, updates or even invalidates the information previously recorded.

In the latter type of application, the method and systems according to this embodiment of the invention provide a low-cost recording media which may be flexible, and in which the recorded information enjoys a measure of protection against the risk of corruption by scratches, dirt, etc. This protection may be enhanced by the addition of transparent protective layers.

Strong signals may be obtained due to the large angle of rotation of polarisation of an interrogating light beam which may occur in an oriented zone of electro-optical activity i.e. greater than the rotations associated with magneto-optical recordings for example. Furthermore, the technique for modulating the exciting field, discussed earlier, enables a very good signal-to-noise ratio to be obtained, and thus gives high reading reliability.

On account of the low cost of the recording media, this embodiment of the invention also lends itself to the making of "tokens", i.e. portable objects such as tickets, cards, tokens and the like, suitable for the recording of a limited number of data items, typically corresponding to consumable units, and disposable whenever their recording capacity is spent. In this type of application, zones or elementary recording units (bits) can be envisaged of a relatively large size. The recording material and the technique used can be selected to provide them with a certain natural immunity against attempts at fraud by simulation or unlawful reproduction.

In general, to reveal the Pockels effect produced by an exciting electric field in an optically anisotropic material, polarised incident light is sent into that material, and the resulting light is detected after passing through the zone examined which was subjected to the electric field. It has been determined that the direction of the incident light in relation to the direction of the exciting field, and in relation to the direction of the orienting field initially used to orient the material is not without significance. It will readily be conceived, therefore, that the possibility of determining and controlling the latter direction provides a valuable means for optimising the operating conditions brought into play.

In the case of a recording, as mentioned earlier, of an orienting field modulated as to intensity, it may be worthwhile, starting with an un-oriented tape, to make a recording of a field oriented in a direction other than perpendicular to the plane of that tape and, for example, parallel to that plane. It may also be of interest to start with a recording tape of which the active molecules have previously been oriented in a direction other than perpendicular to the plane of the tape and to make a recording of bit-data by locally heating that tape in the presence of an electric field different from the initial orienting field, or of a null electric field.

Another typical use considered for such an electro-optical material is the detection of an exciting electric field, or the revealing of an image of that field in the material, using an optical means of detection, for example by polarimetry or interferometry. The operating conditions, particularly the direction of incidence of the light which may be used to effect that detection, depend upon the relative direction of the field that it is sought to detect, or to reveal, in relation to the initial direction of orientation of the electro-optical molecules of the material.

The invention will be further understood in the light of the following description, referring to the drawing, in which:

- Figure 1 is a side-view schematic diagram of the device in accordance with the invention for writing and reading data on a tape;

- Figure 2 shows a first form of implementation of the means of reading of the device in figure 1;

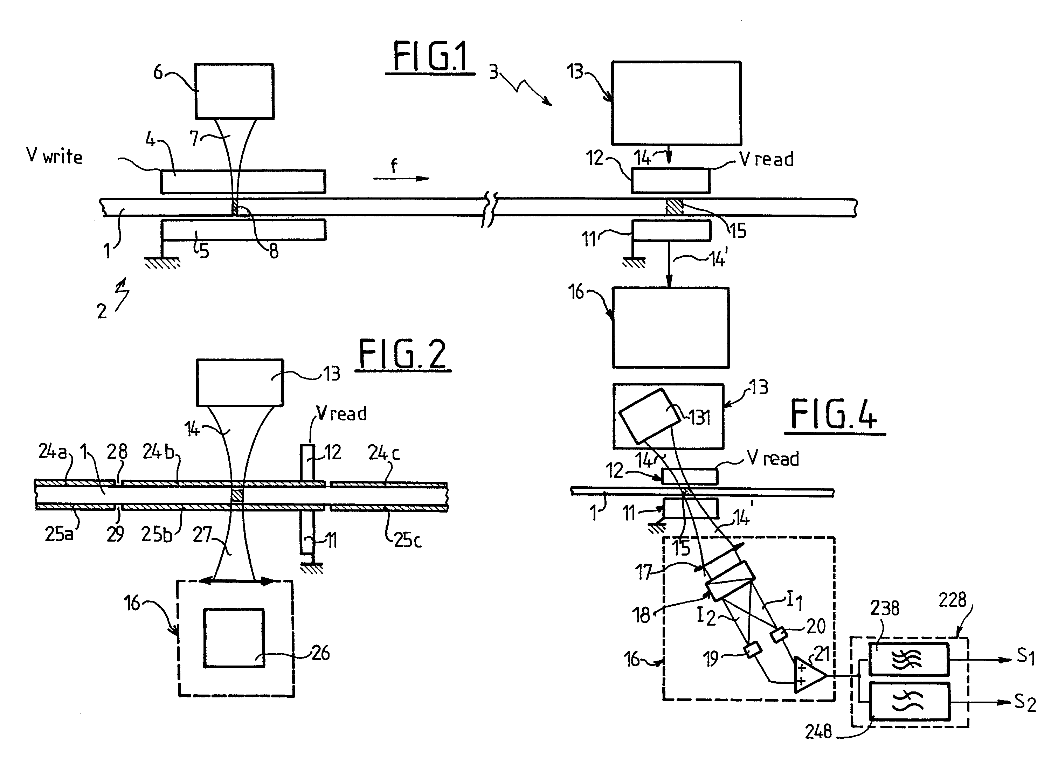

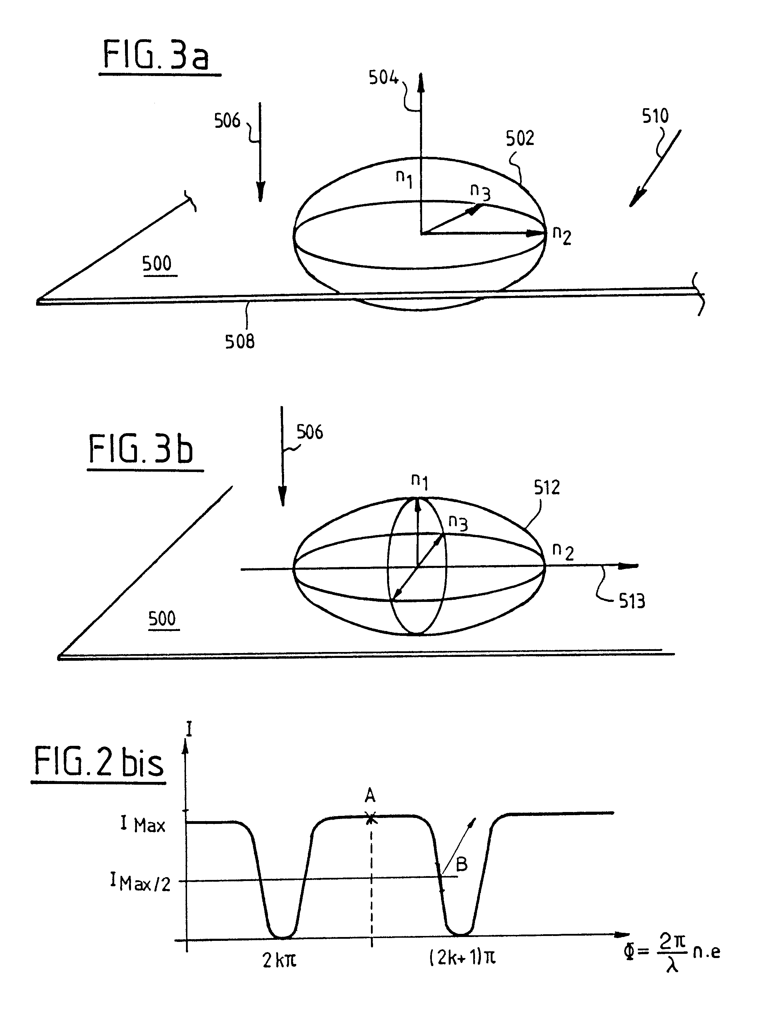

- Figure 2bis shows a curve describing the variation in light-intensity of the output signal from the means portrayed in figure 2;

- Figures 3a and 3b illustrate the anisotropy of the refractive index of an electro-optical material;

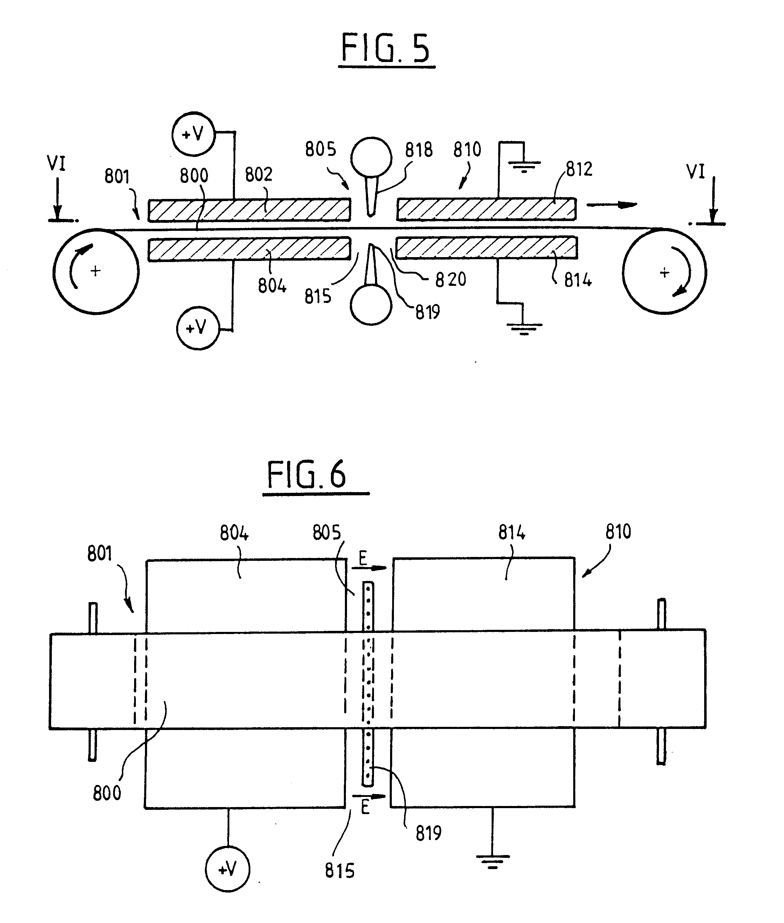

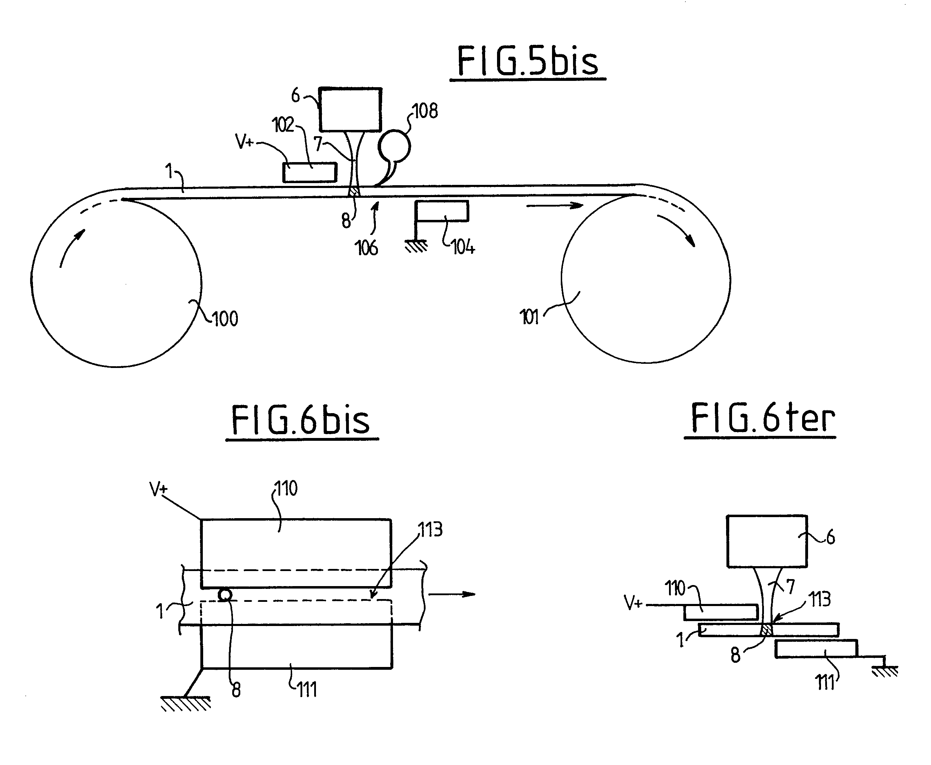

- Figure 4 shows a second form of implementation of the means for reading the device shown in figure 1;

- Figures 5 and 6 give a diagrammatic representation of a variant of the means for reading the device in figure 1, in section and in overhead plan;

- Figures 5bis, 6bis and 6ter represent variants of the means for orienting the molecules in a direction other than orthogonal to the plane of the film;

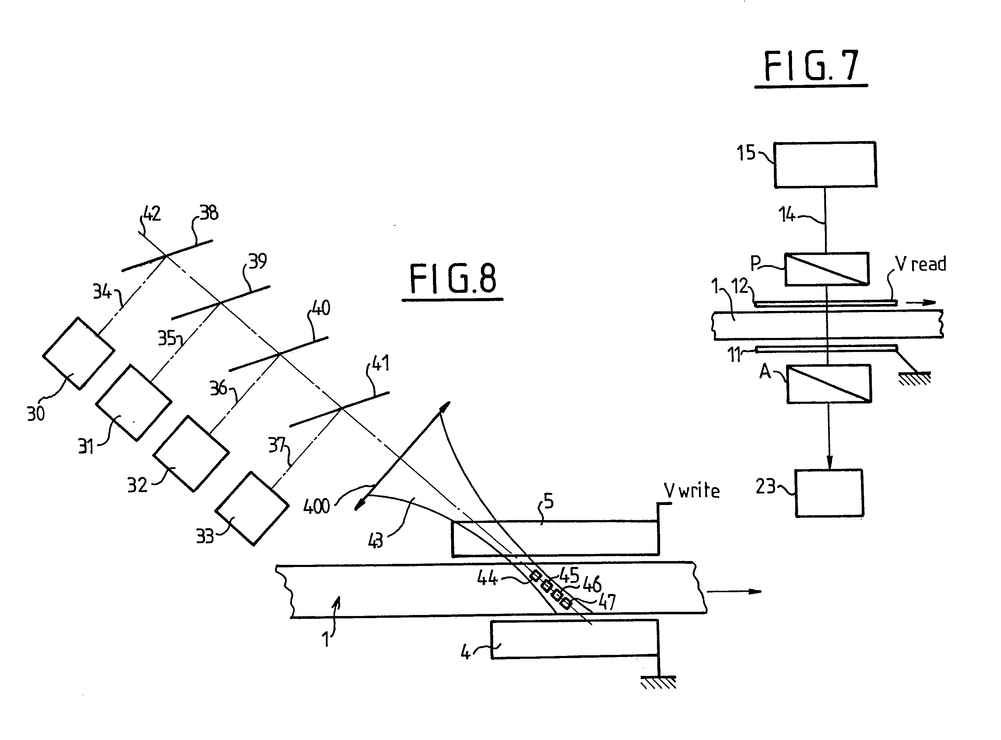

- Figure 7 shows a third form of implementation of the means for reading the device in figure 1;

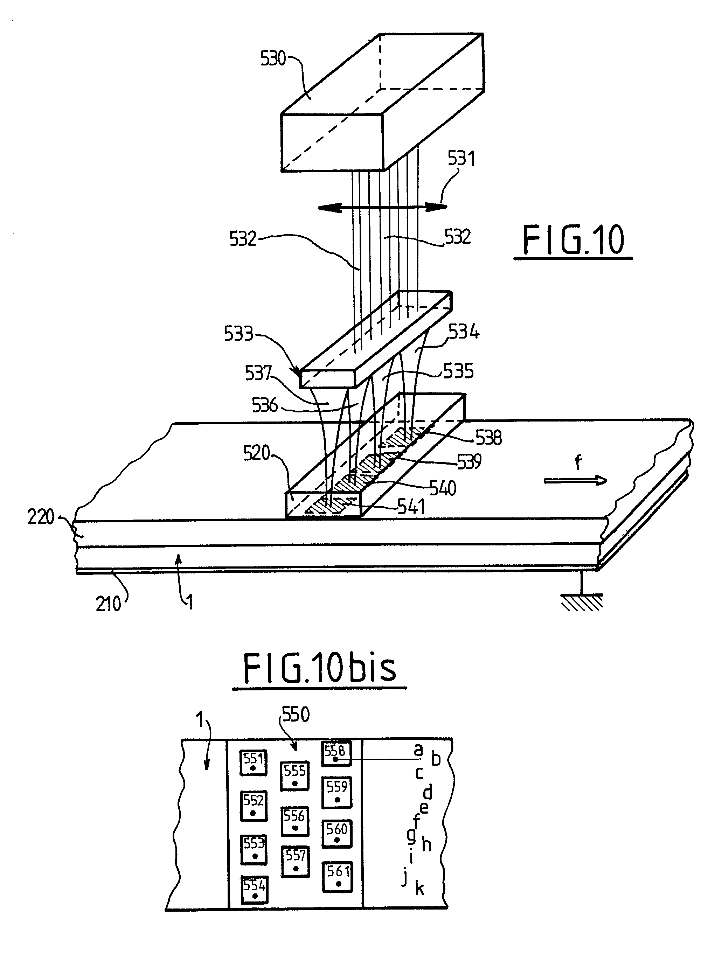

- Figure 8 shows a diagrammatic side view of the means for writing, allowing writing at several levels in the thickness of the tape;

- Figure 9 is a side-view of the writing means for locally applying voltage across the tape;

- Figure 10 is a variant of the device in figure 9, for writing a plurality of tracks in parallel on the tape;

- Figure 10bis is an overhead view of a variant of the electrode unit of figure 10;

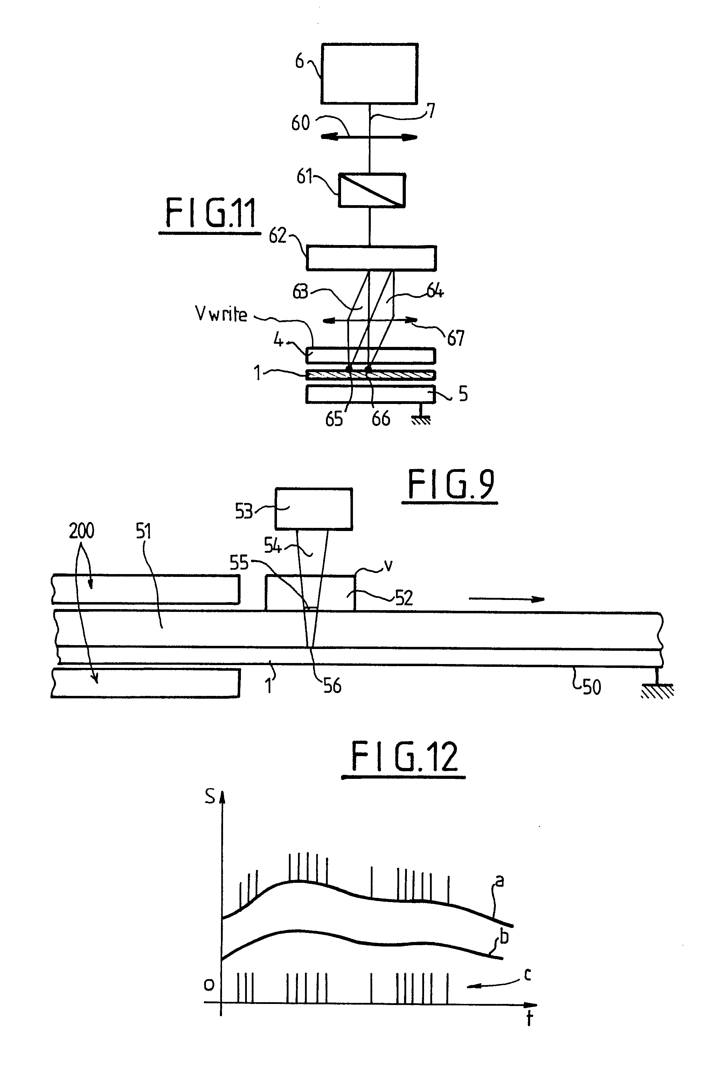

- Figure 11 is a diagrammatic front view of a form of means for reading, such as to allow writing to several parallel tracks;

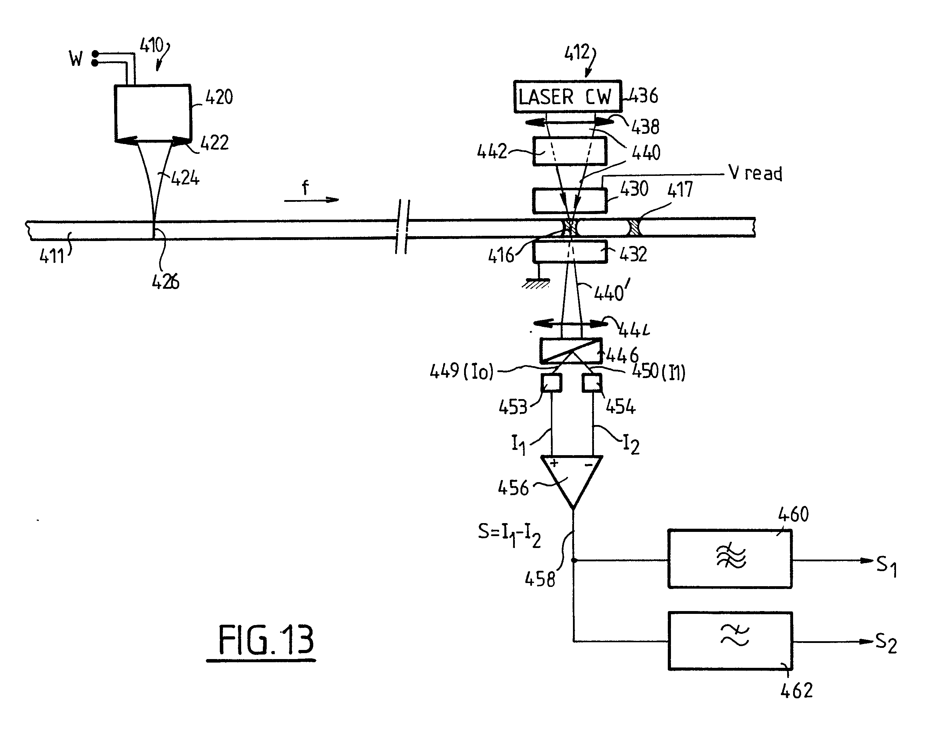

- Figure 12 shows the fluctuations in the reading signal in relation to time;figure 13 is a diagram of a recording system according to another aspect of the invention;

- Figure 13 is a diagram of a recording system according to another aspect of the invention;

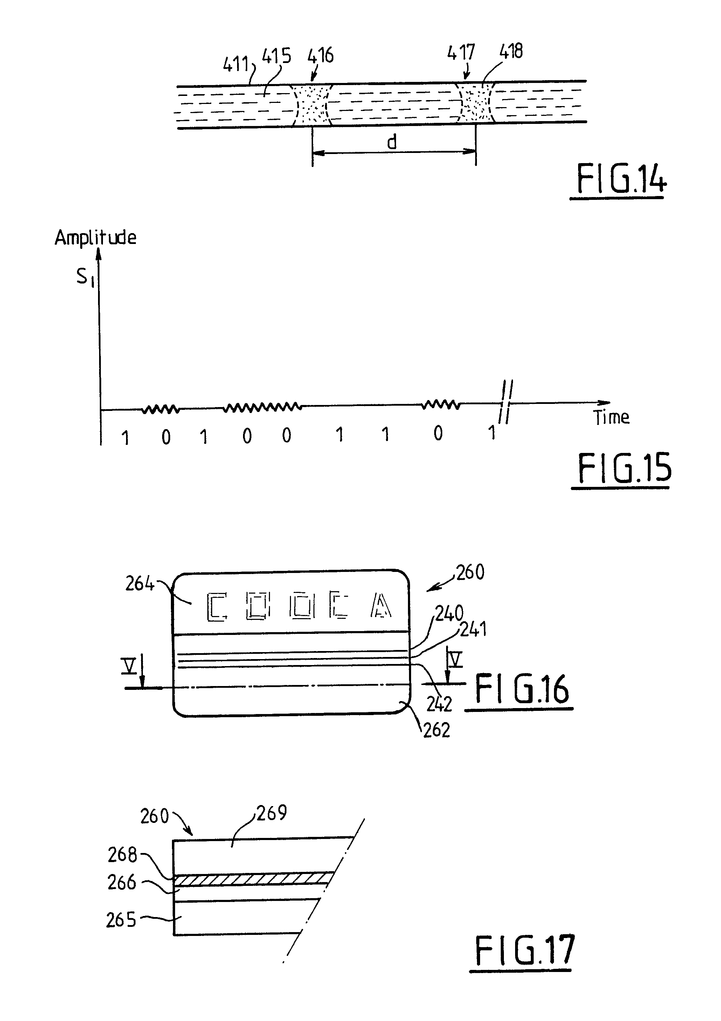

- Figure 14 is a transverse cross-section diagrammatically illustrating the structure of the recording media as used in Fig.13;

- Figure 15 is a diagram of the signals obtained when reading with the embodiment of fig. 13;

- Figure 16 represents an implementation of an electro-optical memory card;

- Figure 17 is a view of the memory card in the transverse section in the direction V-V of figure 16;

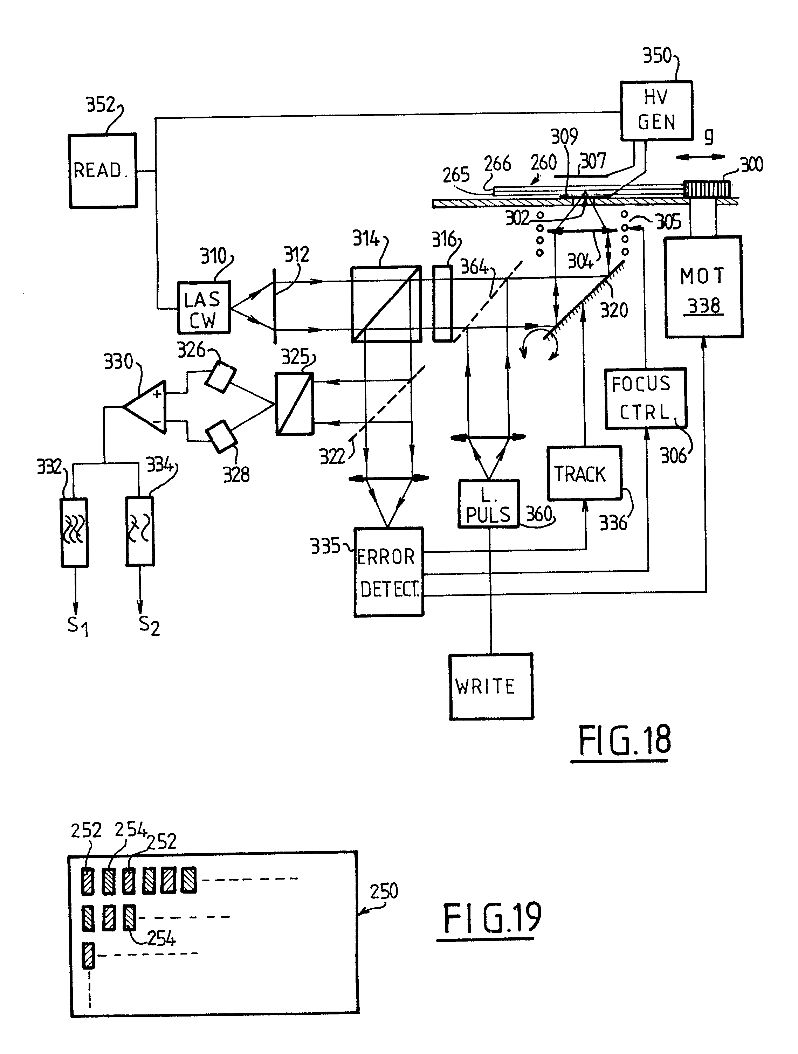

- Figure 18 is a diagram of a memory-card recording/reading system;

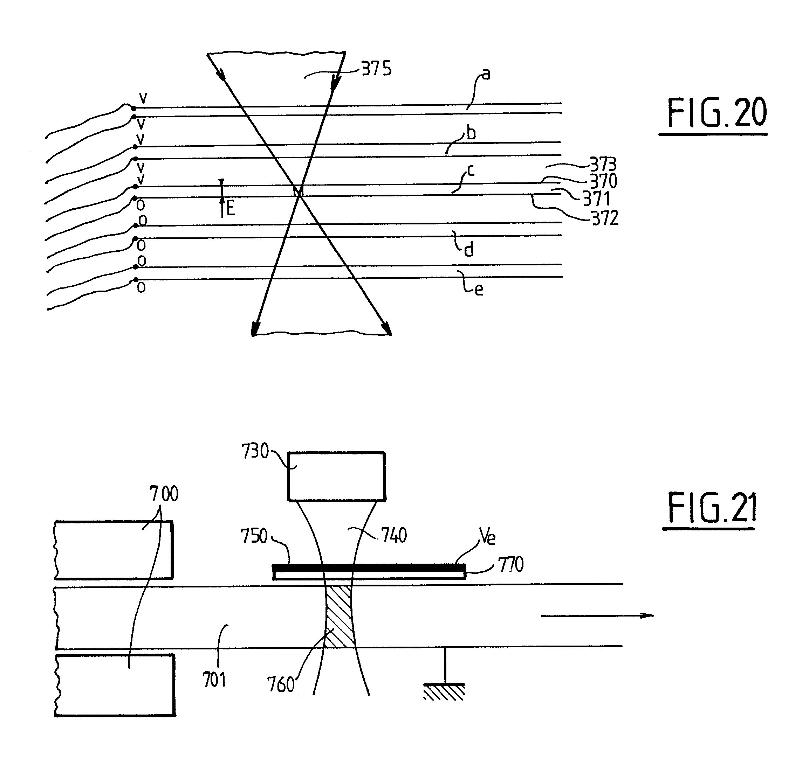

- figure 19 illustrates a token for implementing one form of the invention;

- figure 20 shows a diagrammatic cross-section of a portion of tape equipped with means for generating local electric fields at different depths;

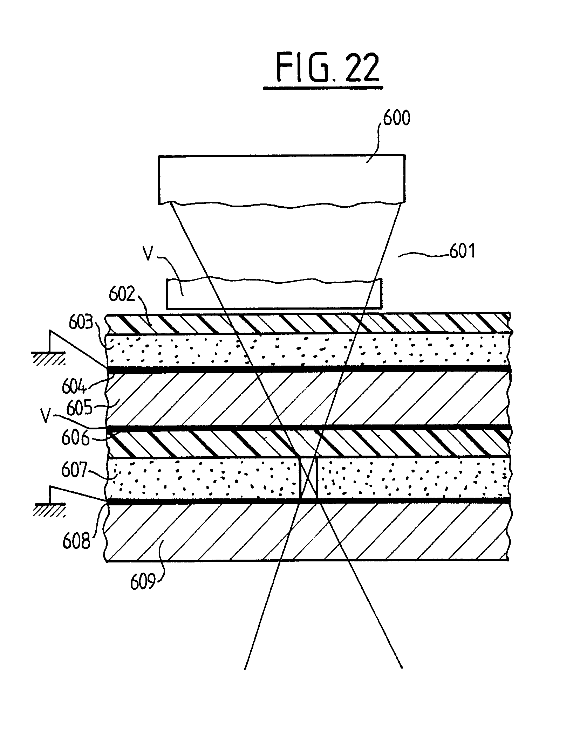

- figure 21 is a side-view diagram of the writing device according to yet another aspect of the invention;

- figure 22 is a diagrammatic representation of a variant of the implementation shown in figure 20.

Crystals with electro-optical properties are already known; the proposal has already been made to use organic materials which exhibit strong electro-optical activity such as MNA (2 methyl-4-nitroaniline) to make crystals that can be used in turning this type of property to account.

MNA crystals exhibit a high $rn^3/e'$ ratio of approximately 50, in which $\underline{r}$ is the electro-optical coefficient, $\underline{n}$ the index, and $\underline{e'}$ the dielectric constant.

Now such a compound may be put to use not only in the form of a crystal, but also in a form combined with a base material in which the molecules of such an electro-optically-active compound are incorporated. As base material, a poly (methyl, methacrylate) PMMA compound can, for example, be used with a density of MNA of approximately 15%. In this case, the MNA is used, therefore, as a dopant of which the molecules are held in the PMMA matrix, in order to render the composition electro-optical. Other possible dopants with electro-optical properties are, for example, the following:-

| DAN | [4-(N,N-dimethylamino)-3-acetamidomitro benzene] |
| COANP | [2-cyclo-octylamino -5- nitropyridine] |
| PAN | [4-N-pyrrolydina -3-acetaminomitrobenzene] |
| MBANP | [2-(alpha-methylbenzylamino)-5-nitropyridine] |

Disperse Red 1, an azo dye as identified for example, in Journal of Optical Society of America B/Vol 4 N°6 June 1987. This type of compound is currently the subject of numerous developments by several firms, universities and research centres in this field, such as Lockheed Missiles and Space company Inc., Hoechst Celanese Corporation and other major firms in chemicals. (See for example communications at the symposium entitled "NATO advanced workshop = "Polymer for non-linear optics", Sophia Antipolis, June 19-24, 1988).

The polymers obtained can be used to form films, fibres or thin or thick layers on any substrate.

A particularly valuable characteristic of this polymers is that they can be used in the form of films capable of being produced in large quantities and at reasonable cost. These films can be used either in a thickness of a few microns (for example, 10 microns) on transparent base materials - glass, for example - or they can be delivered directly in the form of flexible films composed by the juxtaposition of several thicknesses of elementary films (for example 500 microns thick). Values from 10 to 50 pm/V can be obtained for the electro-optical constant r of these materials.

The electro-optical films mentioned above can be obtained by fusion or solution processes. After solidification or drying, the molecules of electro-optically-active products are retained in the bonds of the film base matrix in the amorphous state, i.e. with no particular orientation. To render the material electro-optical it is necessary to confer upon those molecules a preferential orientation within the material. This orientation may be perpendicular to the surface of the material, parallel to that surface, or oblique.

If the temperature of the material is greater than the transitional temperature, the active molecules enjoy a degree of mobility within the bonds of the matrix in which they are held. The value of that temperature, called the critical or transitional temperature, may vary according to polymer. In this state, some molecules are capable of being oriented in the direction of an electric field called the orienting or polarising field. The stronger that field, the higher the proportion of active molecules that is oriented in its direction. Field values of the order of 10 to 100 kVolt/mm can be brought into play. The direction of orientation of the molecules depends on the polarity of the electric field.

With currently available polymer films the critical temperature may lie in the neighbourhood of 100 to 150°C. When the molecules are subjected to the electric field, the temperature is brought down below the critical point. The matrix bonds block the active molecules which, however preserve their orientation. The material thus preserves an oriented structure which can be revealed by the appearance of birefringence, the Pockels or the Kerr effect, in the presence of a reading electric field, also called an exciting or revealing field. When the film is struck by incident light polarised linearly or circularly in the absence of an electric field, the light transmitted by or reflected from the film suffers no change in its polarisation. On the other hand, in the presence of an electric field, the transmitted light suffers elliptical polarisation the degree of which is related to the intensity of the exciting field applied.

The description which follows is made by reference to a recording media in the form of a film or tape, it being understood that the invention is not confined to this type of media; the media may also be constituted by a disk. Figure 1 shows a side view (in its thickness) of a tape 1, constituted by a polymer of the type discussed earlier. The tape is, for sake of illustration, 10 to 100 microns thick, and 5 to 300 mm wide (transversely to the plane of the figure).

The device represented diagrammatically in figure 1 includes means of writing 2 and means of reading 3. According to the example represented, the means of writing 2 comprise firstly, means for generating a global electric field, including two electrodes made up of two conducting plates, 4 and 5, capable of being connected to ground and to a direct-current potential Vwrite, respectively, and secondly, means for providing local heating comprising an emitter 6 of a laser beam 7, capable of being focused on a defined zone 8 or location (of 1 to a few microns) on the tape 1; the aforementioned electrodes 4 and 5 are additionally capable of letting through the light from the laser beam (e.g. through an opening or slit not shown); the direction of the writing laser beam 7 is orthogonal to the plane of the film. Plates 4 and 5, in e.g. tin oxide ($Sn\,O_2$), are disposed opposite each other, and separated from each other by a distance slightly greater than the thickness of the tape in order to enable tape 1 to travel between them. The tape is capable of being given longitudinal translational movement, as indicated by the arrow f, by driving apparatus that is known in itself and is not represented; similarly, the tape guiding apparatus which is also known in itself and is not represented, is intended to cause the tape to follow a given path with respect to the read/write device of the invention.

The means of reading 3, disposed for example down the travel path from the writing means 2, comprise means for generating an electric field that include two electrodes composed of two transparent conducting plates 11 and 12, disposed facing each other in such a way as to leave a space in which the tape is able to travel, and capable of being connected to ground and to a direct-current potential Vread respectively. The means of reading also include an emitter 13 of a laser beam 14, focused on a given zone or location 15 of the tape, and means 16 of analysis and processing of the output signal. Zones 8 and 15 respectively touched by the write laser beam 7 and the read laser beam 14, are of appreciably identical dimensions - longitudinally -(i.e. one to a few microns).

The operation in principle of the device in figure 1 is described hereinafter according to a first form of implementation.

Tape 1, which is caused to travel (at a constant speed from a few tens of cm/s to a few m/s) past the means of writing 2, exhibits no particular orientation of the electro-active molecules. The upper electrode plate 5 is raised to the positive potential Vwrite; the tape is subjected between the electrode plates 4 and 5 to what is called a writing electric field; the laser emitter 6 emits a luminous pulse 7 focused on a zone 8 of the tape which is thus raised to a given temperature T greater than a critical temperature $T_c$ defined as the threshhold temperature necessary to allow, in the presence of an electric field, a given orientation of the molecules; in one example of a matrix of PMMA with a Disperse Red 1 dopant, such temperature Tc is about 110°C ; the zone 8 heated by the heating light-pulse of approximately $10-6s$, travels towards the right of the figure, and remains at a temperature T greater than $T_c$ for a time lying between 1 ms and 0.1ms, while still remaining subjected to the writing electric field; during this time, a preferential orientation of the molecules takes place in zone 8, which then cools under the aforementioned electric field; zone 8 thus exhibits an alteration in the orientation of the molecules, whereas the rest of the tape exhibits no modification in this respect; zone 8 thereupon defines a datum in the form of a bit assigned the 1-state, while the non-electro-optical part of the tape is assigned the 0 state.

The information is thus recorded, or written, on the tape in the form of a succession of bits constituted by zones which are respectively oriented and non-oriented.

The power of the writing laser emitter lies between e.g. 10 and 50 mW. The duration of the time-interval during which the heated zone must remain subjected to the writing field in order to fix the orientation of the molecules, lies between e.g. $10^{-3}s$ and $10^{-4}s$; allowing for the values of the speed of tape travel (a few m/s), the "working" length of the writing electrodes - between the writing beam and the downstream edge of the electrode - lies e.g. between 0.1 mm and 5 mm. On the other hand, the determination of the length of the read electrodes is less critical, since reading is effected by "instantaneous" optical analysis of the state of the zone examined, without that zone having to remain for a given time under the reading field.

The datum may be read by the means 3 represented in figure 2, disposed downstream from the writing means 2 described above. The means of reading include means for optical analysis 16 of interferometry type, such as those based on the use of an analyser known as a Fabry-Perot analyser. The reading beam 14, emitted by the emitter 13, and orthogonal to the plane of the film, partly passes through the plane of the film and is partly reflected on semi-transparent mirrors disposed on either side of the tape 1; the said mirrors are composed of segments of thin film 24a, 24c, 25a, 25b, 25c deposited on the lower and upper faces of the tape.

The film segments forming the mirrors are conductors and are respectively connected, for each face of the tape, to a potential Vread by an electrode 12 and to ground by an electrode 11. The thin films 24 and 25 are interrupted at regular intervals along the tape by spaces 28 and 29 separating two consecutive segments of film; this is so as to prevent the upper face (at potential Vread) being in electrical contact with the lower face, when the tape is wound onto a spool, for example.

Between the parallel layers 24 and 25, interference occurs on both faces of the film; the light beam transmitted from the film is directed towards the means of optical analysis 26 capable of measuring the intensity of the light signal 29. In a manner which is known, the intensity of the interfering light depends upon the distance separating the mirrors, i.e. the thickness "e" of the film, the wavelength "lambda" and the refractive index "n" of the material of which the film is made. Now the refractive index "n" varies according to the orientation of the molecules of the film.

The intensity of the reflected light is varied by the electrical potential applied to the electro-optical film according to a law known as Airy's law. The measure of the intensity of the output light signal provides a measure of the index n. In order to remedy the consequences of any possible differences in the thickness of the film or of the electro-optical tape, on the part covered by the semi-transparent mirrors, a light source can be used that can emit a light beam of variable wavelength (lambda); this enables the point of operation of the device to be shifted along the characteristic intensity curve (figure 2bis) according to the relation:

PHI = [2pi/lambda] n e,

from a point A lying on a first portion of the curve where I = Imax regardless of the value of PHI (therefore of nil sensitivity) to a point B lying on a second part of the curve where I (included between Imax and 0) varies sharply depending on the value of PHI; the sensitivity is a function of this variation in I about point B on that second part of the curve; for preference, point B corresponds to approximately Imax/2. Once point B has been determined, the measurements are then made with the wavelength corresponding to point B.

As a variant, still in accordance with the invention, the reading means are of polarimetry type. However, the means of polarimetric analysis cannot be used without a few precautions in the case illustrated in figure 1 where the active molecules are oriented in write mode in response to a field which is orthogonal in direction to the plane of the film and where the revealing electric field applied by electrodes 11 and 12 is also orthogonal to the plane of the film.

This is because the anisotropy of the material is defined by the ellipsoid of the refractive indices, including several axes.

In figure 3a, the distribution of the indices is represented in an electro-optical film 500 made with a polymer of the type discussed earlier, of which the molecules have been oriented by applying what is called an orienting electric field, in a direction normal to its surface, while its temperature was lowered below the critical temperature below which the molecules of the electro-optical dopant lose their mobility. In 502, an ellipsoid is shown that describes the distribution of the refractive indices of the material when an electric field is applied to it (known as the reading or revealing electric field) perpendicular to its plane. This ellipsoid describes the variations in the refractive index of the material according to the directions in space. It has a symmetry of revolution with respect to the normal 504 to the plane of the film 500 which reflects the fact that the material is optically isotropic parallel to the plane of the film.

If the film 500 is lit by a polarised beam 506 of normal incidence to the film, the light then transmitted by the film (by transmission or after reflection at the opposite face 508 of the film) will not undergo modification of its state of polarisation. That explains why it cannot be determined whether the molecules are oriented or not. On the other hand, an incident beam 510 oblique with respect to the plane of the film will have its state of polarisation altered.

Accordingly, in order to implement the means of polarimetric analysis, when writing, the molecules should be oriented in a direction that is not parallel to the direction of the field and/or the reading laser beam. This lead to a choice between two solutions, either to write by orienting the molecules in a direction orthogonal to the plane of the film and to read with the aid of a field oblique or parallel to the plane of the film, or else to write using a field parallel or oblique to the plane of the film and to read using a laser beam orthogonal to the plane of the film.

Figure 4 is a diagrammatic representation of the means for ensuring polarimetric reading, adopting the first of the two alternatives in the foregoing paragraph, enabling the anisotropy of the material that has been previously oriented using a writing field and laser beam orthogonal to the plane of the film (means of writing 2 in figure 1) to be revealed.

For this purpose, the tape 1 subjected to the reading field orthogonal to the plane of the film, is lit by a reading laser beam 14 emitted by the laser emitter 131 and glancing obliquely with respect to the normal of the film 1; in the position shown, the incident beam is compulsorily directed in a plan parallel to the longitudinal direction of tape 1. It can be arranged that the beam can be inclined in a plane perpendicular to that longitudinal direction, which decreases the longitudinal outer dimension of the reading device. The upper plate 12 is raised to a positive potential Vread in such a way as to place the tape in what is termed the reading electric field normal to the plane of the tape. The reading beam 14', after passing through the tape, is received by the means of analysis 16 of polarimetry type and including a lens 16 that focuses the beam of intensity $I_0$, a polarisation separator 18 (e.g. in the form of a Wollaston prism), two photodetectors 19 and 20 (receiving intensities of $I_2$ and $I_1$ respectively) the outputs from which are connected to a differential amplifier feeding input to an electrical signal processing circuit 22. The beam 14' coming out of the film is oblique with respect to the normal of the film and so likewise are the optical axes of the optical items 17, 18, 19 and 20.

Reading is based on the detection and measurement of the rotation of the polarisation of the light induced by the electro-optical effect of the material of which the tape is made.

The means of analysis 16 therefore detect a succession (and alternation) of zones said to be oriented and non-oriented, such as the hatch-marked zone 15. The signal S detected at the output from the amplifier 21 is:-

$S = I_1 - I_2 = I_0 \sin Theta$

where Theta is the angle of polarisation; we have

$Theta = A \, Vread,$

with

$A = B \, Vwrite$

where B is a constant representative of the physical parameters of the tape.

According to the second of the alternatives seen earlier, in order to enable means of polarimetric analysis to be used, a tape is used of which the molecules are oriented parallel to the plane of the film. In a first method of implementation, this tape is cut from a film of which the molecules have been globally oriented beforehand, with the writing being performed by locally heating the film in the absence of a field. A process for obtaining such a pre-oriented film is described hereinafter with reference to figures 5 and 6, showing a cross-sectional view and an overhead view respectively of a device enabling such pre-orientation to be performed.

A polymer film tape 800 is let into a tunnel-kiln 801 heated to a temperature T slightly higher than the critical temperature referred-to earlier. The tape is guided into the air gap between two facing metal plates 802 and 804 which are maintained at the same direct-current electric potential +V. At the exit from the tunnel-kiln, the film passes into a second tunnel bounded by two facing metal plates 812 and 814 which are maintained at e.g. a nil potential. This results in the interval 815 between the exit from the heating tunnel 801 and the second tunnel 810 being subjected to a substantially uniform electric field parallel to the plan of the tape 800 which travels over that interval 815. The electro-optically-active molecules in the film tend to orient themselves parallel to that direction under the influence of that field immediately at the exit 805 to tunnel 801. Two banks of nozzles 818 and 819 on either side of film 800 are arranged to vent into the interval 815 where they vent a stream 820 of inert gas, e.g. argon or sulphur hexafluoride $SF_6$ cooled to -40C onto both faces of film 800. The gas is drawn between the plates in the second tunnel by a device which is not shown. The temperature of film 800 falls below the critical temperature in the interval 815. The active molecules preserve a preferential orientation along the plane of the film which completes its cooling in the second tunnel.

In figure 3b is represented in 512 the ellipsoid of the indices obtained in the same material under the effect of a detecting or revealing electric field normal to the plane of the film when the molecules of the film 500 have been previously oriented parallel to the plane of that film by the orienting electric field. In this case, the ellipsoid of indices 512 exhibits a symmetry of revolution about an axis 513 in the plane of the film 500. A normal incident beam 506 will then have its angle of polarisation changed as a function of the difference between the indices n2 and n3 along the major axes of the ellipse in the plane of the film. This being so, the assembly in figure 1 (i.e. with normally incident light used for reading) with polarimetric means of reading, enables the effect created by the electric field and the reading laser beam in the polymer film to be exploited.

In write mode, tape 1, including a polymer film that has previously undergone orientation of the molecules parallel to its plane is caused to travel past the means of writing 2 in which the electric field is nil, Vwrite = 0. In the zones locally subjected to the write laser beam 7 the prior orientation of the molecules is lost after being raised above the transitional temperature, whereas the rest of the tape preserves the prior orientation. Reading is performed with the means of polarimetric analysis, of the type of means 16 in figure 4. However, for the reasons discussed with reference to figure 3b, in this case a polarised reading beam of nil incidence (orthogonal to the plane of the film) is used, and not in this case an oblique beam. The write bits corresponding to heating in write mode will be charactersied by an unaltered state of polarisation of the light passing through them.

In the form of implementation just described (with the molecules globally "pre-oriented" beforehand), writing consists of locally destroying the orientation imparted to the material. In a second mode of implementation, a tape is used of which the molecules are not oriented at the outset; writing consists of locally orienting the molecules parallel to the plane of the film. Means of writing enabling this goal to be achieved are shown in figure 5bis. A tape 1 (its thickness is enlarged in the diagram for sake of clarity) travels from a feeder spool 100 to a take-up spool 101, between both of which are disposed means for locally orienting the molecules comprising a first electrode 102, connected to a potential V+, set up facing one face of the tape, and a second electrode 104 set up to face the other face of the tape, but offset from the first electrode 104; the second electrode 104 is connected to ground. The electrodes are set up apart from one another in such a way as to leave a space 106 in which there is a writing electric field appreciably parallel to the longitudinal axis of the tape, or more exactly, slightly oblique with respect to that axis. Opposite the aforementioned space 106 are set up on one hand, an emitter 6 of a laser beam 7 focused on a defined area 8 of the tape 1, and on the other (downstream from the laser-beam emitter 6) a nozzle 108 capable of venting a current of neutral gas (e.g. argon) cooled to a temperature very much below the critical temperature Tc (e.g. -40C). The zone 8 subjected to the laser beam 7 is thus heated by the latter above temperature Tc, while remaining subject to the electric field existing between electrodes 102 and 104; the nozzle 108 is directed in such a way as to cool zone 8 as soon as it has been heated by the writing laser beam 7, while at the same time cooling zone 8 under the electric field in order to fix the orientation of the molecules in zone 8.

Figures 6bis and 6ter give diagrammatic representations in overhead view and front view respectively, of a variant of the means of writing enabling the molecules to be oriented substantially parallel to the tape in a direction transverse with respect to the longitudinal axis of such tape. The device includes two lateral electrodes 110 and 111 placed on either side of the tape, one, 110, facing one face of the tape, and the other, 111, facing the other face of the tape but offset transversely from the first electrode 110 in order to leave an oblong air gap 113 in the longitudinal direction of the tape 1. Electrodes 110 and 111 are connected to a positive potential V+ and to ground respectively. The electrodes thus create an electric field passing right through the tape as it were and in a direction inclined with respect to the plane of the tape or approximately parallel to it. A laser emitter 6 set up above the tape emits a beam 7 (orthogonal to the plan of the figure 6bis) capable of heating a defined zone 8 of the tape, which then cools while under the electric field within the air gap 113.

According to an advantageous form of implementation, the means for reading and writing may be contained in a single unit; the write and read electrodes are then constituted by the same lower plates 4, 11 (figure 1), connected to ground, and upper plates 5, 12 raised to a potential of either Vwrite for writing or Vread for reading.

In the foregoing description (relating to figures 1 to 6), the devices described perform the writing by local heating under an electric field applied uniformly and globally. As a variant, these respective writing operations may be performed by uniform heating (not in this case by laser, but in a kiln, for instance) and by local application of an electric field, e.g. by deposition of electrostatic charges on the surface of the tape (using an electron-gun for example).

Writing is preferably performed at a wavelength at which the tape material is relatively absorbent, and reading at a wavelength at which the tape material is of low absorbency (to enable satisfactory transmission of the reading beam). As an example, He-Ne lasers (633 nm) and Krypton lasers (647 nm) can be used as the focused light (heat) source.

Figure 7 shows a third form of implementation of the means for reading, including, apart from electrodes 11 and 12, means of polarimetric analysis that are simplified compared with the means 16 shown in figure 2 (bearing in mind the quantitative significance of the signal detected). The means of analysis comprise a polarizer P disposed between the emitter 13 of the laser beam 14 and the tape media, a quarter wave plate Q, and an analyser A set up the opposite side of the tape media, as well as a single photodetector 23. The parameter to be measured is the intensity of the output light signal. The orientation of the molecules in the recorded tape is parallel to the plane of that tape.

Figure 8 shows another example of an implementation enabling writing to be performed in the thickness of the tape at several levels. For sake of clarity, the drawing is not to scale in the sense that the tape and electrodes are exaggerated in this representation.

Tape 1 travels between the electrodes 4 and 5 connected to the ground and to a potential Vwrite respectively, and capable of letting through the light from a writing beam. Several laser emitters, in the case in point four, referenced 30, 31, 32, 33, are capable of emitting beams 34, 35, 36, 37 respectively; semi-transparent mirrors (aligned along an axis oblique with respect to the longitudinal axis of the tape) 38, 39, 40, 41 reflect the four respective beams along a single direction 42 that is oblique with respect to the longitudinal axis of the tape in the path of which is a lens 400 which focuses the beam 43 that passes through it onto a zone 44 (hatched on the figure) of the tape situated at a given level in the thickness of the tape, i.e. in the plane of figure 4. Emitters 30, 31, 32, 33 emit light beams at differing respective wavelengths, and such that each beam is focused onto a given level 44, 45, 46 or 47. Beam 43 focused by lens 400 heats a zone at a given level within the electric field applied by electrodes 4 and 5, modifying the orientation of the molecules in the said zone. The active molecules in the zones written-to are therefore oriented within an electric field orthogonal to the plane of the tape.

Reading is performed in the same way, successively focussing an oblique reading beam in the direction of alignment of the zones in increasing order of depth recorded in write mode in each of the zones. The means for reading include in this case the same components as in figure 2, viz. two reading electrodes and the means of polarimetric optical analysis 16 already described with reference to figure 2.

For preference, the bits of like obliqueness within the thickness of the tape are sufficiently distant from one another to ensure that, during reading, the influence of the bits situated above and below the bit on which the reading beam is focused is negligible. As an example by way of illustration, the bits have a height dimension (in the direction of the tape's thickness) of 1 to 5 microns; the number of levels may lie between five and ten.

In connection with the description of figure 8, the same result, viz. focusing a beam onto differing depths in the thickness of the tape, can be achieved, as a variant, using a single laser-beam emitter emitting a beam of a given wavelength and a variable-focus lens placed between the emitter and the tape.

Figure 9 shows another example of implementation of the device enabling a local electric field to be created by deposition of localised electric charges on the surface of tape 1. The electric field can be modulated either digitally (all or nothing) or in a quasi-analogue mode; in the latter case, information is recorded in an analogue or quasi-analogue fashion, i.e. to each zone is applied an electric field of which the value may vary as a function of the value of a variable analogue signal to be recorded. In the quasi-analogue mode, the value of the writing electric field in each discrete recording zone is selected from a among number of discrete values in a range of analogue signal variations of to be recorded. The reading of information recorded in accordance with the invention brings into play physical phenomena which first, are of high magnitude, e.g. of the order of ten to several tens of degrees of bi-refringence and secondly, are proportional to the writing voltage. Thus it is possible to distinguish from each other two zones which have been oriented by different write voltages.

The device in figure 9 includes means for globally heating the tape, known in themselves, such as a tunnel kiln 200. Means of writing described hereinafter, are included down-tape from the kiln 200 in order locally to raise the upper part of the tape to a given potential. Tape 1 includes on one of its faces a film 50 that is conductive and transparent, constituting an electrode connected to ground, and on the other face a layer 51 of a polymer material exhibiting photoconductive properties, i.e. of which the conductivity depends on the degree of illumination (for example a carbon loaded polyethylene or a polyacetylene film). Facing the transparent photoconductive layer 51 and in contact therewith is set up a transparent electrode 52 connected to a potential v, being either modulated digitally (all or nothing) or of analogue or quasi-analogue type. A laser 53 is included that is capable of emitting pulsed laser beams 54 focused on a given zone 56 of the tape 1. Under the effect of beam 54 a conducting channel is created between zone 55 lying on the upper part of the photoconductive layer raised to potential v, and zone 56 in the upper part of the tape on which the control beam 54 is focused; zone 56 is thereupon at potential v and accumulates electrical charges which are maintained in zone 56 on account of the non-conductivity of the polymer of which tape 1 is made, so creating an electric field in the thickness of the tape under the effect of which the electro-active molecules are oriented. The tape is raised, up-tape from the means of writing, to a temperature such that it remains at a temperature above the critical temperature Tc for a sufficient length of time after the appearance of potential v on the zone to be polarised, for the orientation of the molecules to take place. The orientation is fixed upon the subsequent cooling of the tape. Reading is performed with the aid of the means of reading such as those shown in figure 2 or those shown in figure 4.

Since the photoconductive effect is virtually instantaneous and devoid of remanence, as soon as beam 54 disappears, the photoconductive layer is no longer conducting. It is possible to cause potential v to vary according to discrete values that are representative of the variations in an analogue signal.

The type of implementation described with reference to figure 9 (enabling the surface of the tape to be raised locally to a given potential) presents the advantage of making use of a low-power laser emitter.

Figure 10 shows a variant of the device in figure 9, enabling information to be written on the tape along tracks parallel to the longitudinal axis of the tape. A unit 520 forming a first electrode is included, comprising a parallelepiped-shaped plate in a rigid, transparent material (such as glass) disposed in such a way that its greatest dimension is orthogonal to the longitudinal axis of tape 1. The lower face of the electrode plate 520 is disposed in electrical proximity (a few microns) to the upper face of a photoconductive layer 220 itself laid on the tape 1; the opposite face of the tape to layer 220 is coated with a layer 210 in a conductive material (transparent, for example) constituting a second electrode connected to ground. The lower face of electrode plate 520 is fitted with square contact-plates or -blocks 538 to 541 made of a transparent conductive material (such as Yttrium oxide) each connected to a given potential (Vwrite or ground). Each contact-block constitutes a unitary electrode, of dimensions e.g. 0.5 mm x 0.5 mm, corresponding to one bit on a given track. A laser emitter 530 is set up some distance from the electrode unit 520 and is capable of emitting a laser beam 532 passing through a lens 531 and striking a diffraction grating 533. The latter is capable of thereby generating several beams 534 to 537, equal in number to the number of unitary electrodes 538 to 541, and respectively focused on each of the latter.

The tape is heated beforehand by a tunnel-kiln - not shown - situated just up-tape from the electrode unit 520 and the optical equipment 530, 531, 533, with respect to the tape's direction of travel (arrow f). Each segment of the tape arriving perpendicularly beneath the electrode unite 520 is at a temperature above the critical temperature. The laser beams 534 -537 pass through the photoconductive layer perpendicularly above the electrodes 538 - 541, causing the latter to become conducting and they therefore create a sort of conducting well towards the base of the photoconductive layer 220, where the charges are deposited perpendicularly beneath the unitary electrodes. On the face of the electro-optical layer forming tape 1, in contact with the photoconductive layer, localised charge-deposits are formed, which create with the second, lower electrode connected to ground, localised electric fields with directions orthogonal to the plane of tape 1.

The distance separating two unitary electrodes must be large in proportion to the distance separating each electrode from the photoconductive layer, in order to avoid all crosstalk between the electrodes. The surface of the electrodes should be designed to be of sufficient size compared with the light-spots of the focused beams 534 - 537 to enable those beams to focus on the electrodes despite the relative distance (in the direction orthogonal to the plane of the tape) of the focal points created by the diffraction-grid 533 and lying on a circle centred on the latter. At the point perpendicularly underlying each unitary electrode one bit is created on tape 1. The unitary electrodes are powered by or connected to a potential Vwrite (bit value 1) or nil (bit value 0). Thus are written on tape 1 several bits in alignment along tracks parallel with each other and to the tape's longitudinal axis.

The implementation example described in figure 10 includes for reasons of clarity four parallel tracks. Obviously, the number of tracks may be higher.

However, bearing in mind the lower limits stated above, the dimensions of the electrodes and distances between electrodes, the number of tracks reaches limits of the order of e.g. a few units. In order to increase the number of tracks without prohibitively increasing the dimensions of the electrode unit 520, the latter is produced as shown in figure 10bis, showing an overhead view of tape 1 and an electrode unit 550 of parallelepiped shape and of which the longest side is orthogonal to the axis of the tape and of length equal to the width of tape 1. Unit 550 is constituted of a glass block having on its lower face close to tape 1, several blocks or plates formed out of a square film (measuring 0.5 mm by 0.5 mm, for example), disposed in rows that are parallel and orthogonal to the axis of tape 1; each block forms a unitary electrode; the example shown includes three rows, the first row comprising four unitary electrodes (551 to 554), the second row, three (555 to 557) and the third row four (558 to 561), so that the centres of the unitary electrodes, corresponding to write bits, are offset one from another in a direction orthogonal to the tape's axis; in other words the unitary electrodes are offset in such a way as not to be strictly aligned about the axis of tape 1. Each unitary electrode 551 - 561 is connected to a potential Vwrite or to ground, and corresponds to one bit, and therefore to one track; tracks a, b, c, d, e, f, g, h, i, j and k are parallel to the longitudinal axis of the tape; recording of several tracks (in the case in point, eleven) is thereby obtained using an electrode unit 550 of relatively small dimensions.

Figure 11 shows the front view, with tape 1 shown in transverse section, of a device for reading the tracks recorded using the writing device shown in figure 10. A laser emitter 6 emits a reading beam 7 passing successively through a lens 60, a polariser 61 and an optical diffraction grid 62 (known in itself) capable of generating several parallel beams 63, 64 focused by a lens 67 on distinct zones 65, 66 aligned from one edge of the tape to the other (i.e. transversely to the axis of the tape). Two read electrodes 4 and 5 are set up on either side of tape 1 and close to the latter, being connected to the potential Vread and to ground respectively. The respective beams coming from grid 62 are focused on a succession of bits aligned transversely to the longitudinal axis of the tape. Bit reading is performed using the means of optical analysis A and 23 such as those shown in figure 7, including a photodetector for each read electrode, i.e. one photoconductor per bit.

In order to offset the consequences of any undue shifting of the tape, the reading device in figure 11 may include means (not represented) for monitoring the position of bits on the tape. For example, such means include a unit for detecting the position of the tape's edge and appropriate means to enable the light beam to be shifted by a value corresponding to the undue shifting of the tape. If the tape were to be shifted translationally in a direction transverse to its axis, the means of travel cause movement of emitter 6 by an equivalent value. In the event of the tape expanding, the means of travel cause the optical grids 62 to tilt in order to enable the position of the bits to be found.

In an advantageous form of implementation (not shown), the device, which conforms to any of the forms of implementation represented and described above, includes first, equipment capable of recording on the tape reference bits constituted by oriented and/or unoriented zones at a constant level and secondly, combined with the reading equipment, means of comparing the signals coming from the data bits (curve a, figure 12) and the reference bits (curve b, figure 12) so as to deliver an output signal (curve c) formed of peaks above an average level appreciably equal to zero. Curve b is representative of the reference signals and therefore of the fluctuations in time of the output signals in the absence of any correction with the aid of the reference bits.

The system illustrated as an example of another embodiment of the invention in figure 13 is composed of a recording device 410, a reading device 412 and a recording media 411. The latter comprises a polymer film forming a matrix within which are held captive the organic molecules possessing non-linear optical activity.

A diagrammatic representation of film 411 is shown in figure 14, of which the molecules 415, which are electro-optically active, are illustrated in the form of long filaments generally oriented in a plane parallel to that of the film. In two zones 416 and 417 passing right through the thickness of the film and separated from each other by a distance d, the molecules 415 have been broken up by a photochemical reaction as explained hereinafter. The molecular fragments 418 resulting from that reaction possess no electro-optical activity. In combination with the neighbouring electro-optical zones, zones 416 and 417 may therefore represent a linear recording of data.

Referring back again to figure 13, zones 416 and 417 are obtained by causing the previously-oriented film 411 to travel past the writing device 410. This comprises a laser-beam source 420 and a concentrator system 442 which focuses a laser beam 424 whose general direction is perpendicular to the plane of film 411 towards a zone of small dimensions 426 in film 411. The film is relatively transparent and the laser beam penetrates it throughout its width. However, the wavelength of laser 420 is selected within the absorption waveband of the active molecules of the dopant, for example 800 nm for the MNA compound mentioned above. The products used as dopants are typically dies which heavily absorb the corresponding wavelengths. Their molecules are relatively unstable at these wavelengths. When the light energy absorbed reaches a critical level, it causes a break of the chemical bonds responsible for the absorption. The result is the creation of zones such as 416 or 417 in figure 14.

Laser 420 is a pulsed laser controlled by a digital signal W corresponding to the data bits to be recorded. Controlling the laser by signal W therefore allows the recording, in the form of zones such as 416 and 417, of data bits relating to a parameter of which the changes correspond to the pace of travel of tape 411.

The device for reading film 411 recorded-on by writing device 410 and travelling in the direction of arrow f includes, set up on either side of the tape path, two electrodes, 430 and 432 respectively. Electrode 430 is intended to be connected to a reading voltage V, which is advantageously alternating, while electrode 432 is connected to the ground of the device. Electrodes 430 and 432 are constituted by thin plates parallel to the plan of film 411, and placed within a short distance therefrom in order to set up an alternating electric field of sufficient intensity e.g. 5 to 50 kVolts/mm within the electro-optical media constituting tape 411.

Device 412 also includes on the side where electrode 430 is located, a continuous CW laser of which the wavelength is chosen in keeping with the electro-optical activity of tape 411 and in a region of the spectrum at which the stability of the dopant molecules is not affected. The material of which electrodes 430 and 432 are made is selected so as to be transparent to the wavelength chosen. The electrode material can, for example, be a tin oxide film $(SnO_2)$ deposited on a glass plate. The laser light projected by source 436 is concentrated by an optical system 438 and passes through a polariser 442 and electrode 430 so that it forms a spot of light on the plane of film 411. Beam 440′ leaving the opposite face of film 411, after passing through electrode 432, is transmitted by a lens 444 which concentrates it onto a separating device e.g. a Wollaston prism 446. At the exit from this prism, two rays are yielded, 449 and 450, falling onto two photodetectors 453 and 454 respectively, the outputs from which are connected to a differential amplifier 456. The output from that amplifier 458 is connected to the input of a band-pass filter 460 and signal II is connected to a low-pass filter 462, which supply at their respective outputs signals S1 and S2 the nature of which is explained hereinafter.

In operation, when laser beam 440, to which is imparted circular polarisation, passes through film 411 in a zone where the active molecules have not been disturbed by a writing operation, the electro-optical properties of those molecules cause an alternating change in the state of polarisation of beam 440 having a frequency and intensity which are determined by the frequency and intensity of the electric field between electrodes 430 and 432. The light emerging from film 411 exhibits elliptical polarisation of which the components along two axes x and y vary alternatingly with the exciting electric field. Beam 440′ emerging from film 411 is divided by the polarisation separator 446 into two beams each corresponding to one of the components of the elliptical polarisation along the x and the y axis respectively. Photodetectors 453 and 454 deliver two electrical signals of which the peak intensities are $I_1$ and $I_2$ respectively. Differential amplifier 456 produces at its output 458 an alternating signal of a maximum amplitude S proportional to:
$$S = I_1 - I_2 = I_0 \sin \Theta$$
in which $I_0$ is the intensity of beam 440 entering film 411 and Theta is the change in the angle defining the elliptical polarisation of beam 440′ due to the electric field.

Signal S is modulated alternatingly at the frequency of the reading electric field. The band-pass filter 460 is centred either on the frequency of that field, in the case where a Pockels effect is detected, or on the double frequency in the case of a Kerr effect. It therefore provides a signal $S_1$ which is only representative of the variations in the condition of the light energy passing through tape 411 due to the Pockels or Kerr effect. Where that energy passes through a zone such as 416 or 417 in which the active molecules were destroyed, no modulation of that light occurs under the effect of the electric field. Signal $S_1$ at the output from the band-pass filter 460 is therefore nil. Signal $S_1$ is therefore not affected by the variations in light intensity of beams 440 and 440′ which may result from various causes such as fluctuations of the power-source or in the transparency of the film, dirt, stray absorptions, etc. On the other hand, signal $S_2$ at the output from low-pass filter 462 reflects the level of light intensity passing through film 411, substantially independently from the Pockels (or Kerr) variation.

Figure 15 is a diagrammatic representation of signal 1 at the output from amplifier 458. The portions that are not modulated at rapid frequency represent written bits obtained by irreversible changes to film 411, while the modulated zones correspond to the opposite value. The frequency of the reading field is chosen so as to supply at least a few periods of oscillation during the period of duration of the bit corresponding to the minimum interval between the detection of two write zones such as 416 and 417 in film 411.

The recording technique just described affords the possibility of obtaining indelible high-density recordings, since the minimum bit-recording size that can be envisaged is limited only by the size of the diffraction spot of the light used on the film. It is therefore conceivable to make bit recordings on a surface of 1 square micron in the film using a pulsed laser with a power of one milliwatt (1 mW). Recordings of indelible type, also known by the acronym WORM (Write Once, Read Many) can therefore be made with recording densities reaching 200 megabit/cm².

The technique described enables recording rates to be achieved of some megabits per second with a 1-milliwatt laser, and a speed of travel of the film of 3 metres per second. The signal level that can be obtained is very high. With a film having an electro-optical constant of 10 to 50 pm/v it is possible to obtain rotations in the angle of polarisation of 10 degrees under a field of 100 volts. In read mode, the rates can be of the same order.

Obviously, in view of its other advantages, interesting applications of the technology described exist, which do not call for such high performances. Such recordings can be made on traditional media, such as tapes or disks. They can also be implemented using media having the format of a card that can be carried in a wallet. The technique described here can be used, for instance, for the recording of memory cards complying in their geometry and mechanically with the ISO standards for credit or payment cards. In all cases, there is benefit from the advantages procured by the high signal level resulting from the reading of the electro-optically-active zones and from the further possibilities of bit discrimination afforded by the possibility of modulating the reading electric field.

Figure 16 gives a diagrammatic representation of the reverse face of a memory card 260 divided into two parts. The lower part contains a zone 262 in which the optical memory is situated, while the upper part is reserved for other uses such as writing, embossing, etc.

Figure 17 shows a diagrammatic sectional view of the lower part of card 260 along line V-V of figure 16. The lower face of the card in zones 262 is bounded by a transparent layer of plastic material 265, of which the thickness can be approximately 0.5 millimetre. An electro-optical polymer film 266 of approximately 10 microns in thickness is laid over layer 265. On the upper face of film 266 a metallic layer 268, such as aluminium, is deposited, of sufficient thickness (e.g. one micrometre) to form a mirror reflecting the light that reaches it through film 266 and transparent layer 265. Above layer 268, the card is coated with a layer 269 of opaque plastic material, e.g. 0.3 millimetres thick, constituting the upper face of the card which can be written or printed on and illustrated.

Figure 18 represents a terminal for the purpose of exploiting card 260. Card 260 is inserted in a trolley 300 capable of causing it to travel in a direction parallel to arrow g past a slot 302, perpendicular to the plane of the figure, from which its lower face 265 can receive an interrogating laser beam in read mode coming from a lens controlled by an automatic focusing system, 305, 306. The reading beam, produced by a continuous laser 310 followed by a lens 312, passes through a polarising separator 314, then through a quarter-wave plate, and then falls onto a scanning mirror 320 capable of oscillating about an axis situated within the plane of the figure. Mirror 320 deflects the reading beam at an angle close to a right angle towards the focusing lens 304.

The beam reflected by reflecting layer 268 (figure 17) in card 260, after passing twice, as described, through the electro-optical film 266, is routed by lens 304, the oscillating mirror 320 and the quarter-wave plate 316 towards separator 314 which deflects it towards a semi-transparent mirror 322. The latter reflects the beam towards a separating analyser such as a Wollaston prism 325 which divides it into two components which are received by photodetectors 326 and 328 respectively, followed, as in the case of figure 13, by a differential amplifier 330 and two filters: a band-pass filter 332 and a low-pass filter 334.

A high voltage generator 350 controlled at the same time as laser 310 by a reading control device 352, enables alternating-current voltage to be applied to electrodes 307 and 309 situated on either side of the path travelled by card 260 past slot 302 to establish an alternating reading electric field in the portion of film 306 interrogated during reading. Electrode 309 is transparent. The reflected beam passing through semi-transparent mirror 322 is used by a positioning error detector 335 which controls:
a device 336 for controlling the position of oscillating mirror 320 to control the position of the reading beam as it leaves slot 302 in the transverse direction in order to enable readings to be made of the recording tracks parallel to arrow g;
the focusing control device 306;
a motor 338 and a drive transmission for trolley 300 to drive it both ways parallel to arrow g.

The device therefore enables readings to be made of the recording tracks of film 266 parallel to the direction along which the card is moved by trolley 300, such as tracks 240, 241 and 242 in figure 16.

A pulsed laser 360 can also be set up in the same terminal for the purpose of writing, and its light, suitably selected to cause the break-up of the active dopant molecules, is transmitted by an optical system 362 towards a semi-transparent plate 364 interposed on the optical path between the separator 314 and the scanning mirror 320. Writing to tracks such as 240, 241 and 242 is therefore possible using the same means for scanning and focusing as when reading.

The invention also enables tokens to be produced that are intended to have a relatively limited number of data items written to them before being thrown away or destroyed.

A token capable of being produced and exploited using a system such as that of the embodiment of the invention is illustrated in figure 19. In this example, the token is constituted by a rectangular plate or ticket 250 of a material containing a fine layer of electro-optical film of the type discussed earlier. This plate is initially divided into a series of alternating pre-recorded zones 252 and 254 distributed over its surface.

In zones 252 (hatched), the active molecules of the polymer have been oriented and fixed in one direction, while in the alternate zones 254 (distinguished from the former by hatching in the opposite direction) the active molecules have been oriented by an electric field along the same axis, but of opposite polarity. The combination of each couple of pre-recorded zones 252 and 254 corresponds to a unit of value of which the token is intended to monitor consumption.

The token may be used e.g. in a public telephone terminal, and contain a certain number of pre-paid units, each represented by such a combination. These combinations of zones are intended to be invalidated in step with the consumption of telephone services until the token's capacity has been exhausted. The invalidation of the zones may be effected by the destruction of the active molecules of that zone by the means discussed earlier. In a token of this type, the size of the pre-recorded zones can be distinctly greater than that of the memory bits discussed earlier. The operations for destroying zones 252 and 254, and the reading operations can be carried out with less stringent tolerances than in the case of a recording of data at very high density.

The application to the token just discussed is of value given that in particular, the making of pre-recorded zones as above for fraudulent purposes is not easy, particularly in view of the resources necessary for recording contiguous zones under intense electric fields of opposite polarity. The process therefore affords scope for manufacturing cheaply, and with good intrinsic security against fraud, tokens containing a limited number of consumable units, those units being cancelled or invalidated by being written-to irreversibly in conformity with the invention. Obviously, particularly in cases where high security -against fraud in particular - is not essential, it is also possible to use as tokens small areas of film that have not been pre-recorded. In this case, it is the write/read terminal which uses its own software to carry out the operations for counting down as consumed the memory zones already written-to, and to make the corresponding calculation of the number of units of consumption remaining available.

An example was described earlier in which irreversible writing to an electro-optical media was effected by photochemical breaking-up of the active molecules in the recording material. The locally-selective destruction of the electro-optical properties of such a material may also be achieved by other means, e.g. by thermal burning or by electrically "breaking up" the material at the points selected. The revealing of the data recorded still enjoys the high signal level that can be obtained with certain polymer electro-optical material, as well as the possibility of using a suitable modulation of the reading field.

Returning to Figure 4 there will be described an improvement in reading a reversible or erasable recording whereby potential Vread is alternatively modulated at a given frequency, e.g. a few tens of kHz.

There are provided further means of electronic processing 228 of the signal output from comparator 21, that include as in the case of fig 13 a band-pass filter 238, yielding an output signal S1, connected in parallel with a low-pass filter 248 outputting a signal $S_2$. The band-pass filter is centred appreciably close to the frequency of modulation of the reading field, while the cut-off frequency of the low-pass filter is appreciably lower than the aforementioned frequency.

Thus, the output signal S1, as in figure 15, comprises an alternating succession of portions at constant level (in the case in point, this is null) representative of 0-bits, and portion of levels modulated at the frequency of modulation of the reading field, representative of 1-bits.

The foregoing description refers to a binary record (0 or 1). It is possible to apply modulation of the reading field to records intermediate between the binary mode (discussed earlier) and the analogue mode, that are constituted by a set of discrete values for the writing signal.

Figure 20 shows a cross-sectional view of a tape forming a data-recording media enabling data to be written to and read from different depths in the tape.

The tape comprises a depth-wise succession of three-layer sandwiches referenced a, b, c, d, and e. Each sandwich comprises a first layer forming a first transparent electrode 370, a second layer 371 in an electro-optical material carrying the data, and a third layer 372 forming a second transparent electrode.

Each sandwich is separated from the next by a separation layer 373 made of an inactive material. The respective thicknesses of the different layer are for example:

electrode layer: 1 000 Angstroem units
electro-optical layer: 1 micron
separation layer: 4 microns

The writing or reading of data on the tape in the foregoing description is effected using, e.g. a device comprising means of local heating as described in relation to figure 8 but which in this example is directed perpendicularly to the surface of the tape.

In order to write to or read from a given layer, c in this example, laser beam 375 is focused on the said layer and the first electrode 370 is connected to a non-null potential V, and the second electrode is connected to ground, creating an electric field in the layer. The electrodes of the layers (or three-layer sandwiches) disposed above the layer undergoing writing/reading are at the same potential as the upper electrode of the latter; similarly, the electrodes of the lower layers are at the potential of the lower electrode of the layer being written-to/read-from.

This avoids all crosstalk between layers lying at different depths, since writing or reading is effected by the simultaneous application of an electric field and of heat, and is performed locally, i.e. solely at the point sought that corresponds to one bit; the latter has dimensions of the order of e.g. 1 micron x 1 micron.

Figure 21 is a diagrammatic, side-view representation of a device intended to enable writing to be performed by application of global heat and of a local electric field, particularly by photoconductive effect.

Tape 701 made of an electro-optical material travels into a tunnel-kiln 700 that heats the said tape uniformly; a laser-beam emitter 730, set up at the exit from the said kiln, emits a beam 740 orthogonal to the plane of the tape. Facing one of the faces (e.g. the upper face) of the tape a conductive platelet 750 is set up and is raised to a potential Vwrite, while the other face of the tape is connected to ground. Between conductive platelet 750 forming an electrode and the corresponding face of the tape, a platelet 770 is provided, made of an insulating material.

The whole of the material of which the tape is made is globally oriented or polarised beforehand by the tunnel-kiln.

The material constituting the tape exhibits, apart from its electro-optical properties, photoconducting properties, i.e. its conductivity increases with illumination.

Laser beam 740 creates a conducting well 760 in the tape, which is tantamount to connecting the parallel faces of the tape electrically; the electric field inside the material in the zone of well 760 is therefore cancelled out.

Writing according to the process described above is therefore performed by local cancelling (at a given bit) of the global orientation previously imparted to the material. As a variant, the insulating platelet can be replaced by an insulating layer overlying the electro-optical and photoconductive layer.

It should be noted that the laser used can be of low power, and in all circumstances of a power far lower than that required to heat for the purpose of writing / reading used in the other modes.

The foregoing description, relating to any one of the aspects of this invention, makes reference to a tape. The invention can also apply to a disk or a card. In the case of a card, since the thickness of the base material is greater, as a rule, than that of the electro-optical layer, it is advantageous to provide at least one conducting layer forming an electrode on one of the faces of the electro-optical layer, so as to reduce the total thickness of layers subjected to the electric field.

Figure 22 shows another example of a data-recording media (in the form of a tape), with several layers, in which information can be recorded at several levels in the thickness of the material. A laser emitter 600 emits a laser beam 601 capable of being focused at a given depth in the material. The tape comprises two multi-layer sandwich sandwiches. The first of these comprises an insulating layer 603, a electro-optical and photoconductive layer as discussed in reference to figure 21, and an electrode layer 604 (connected to ground); the second sandwich comprises a first, electrode layer 606, an electro-optical and photoconductive layer 607, a second electrode layer 608 connected to ground; both multi-layer sandwiches are separated from each other by a separation layer 605 (made of an electro-optically-inactive material), while the second sandwich overlies another separation layer 609. Facing the upper face of the tape (i.e. facing insulating layer 602) a conductive plate is set up that is raised to a potential V. The electrode layers in the tape are capable of being connected to that potential V. Just as described in relation to figure 21, laser beam 601 creates a conduction well in a limited portion of the electro-optical and photoconducting layer 607, thereby causing the field inside the said portion to be cancelled out.

## Claims

1. A method for recording information on a recording media comprising a polymer material including electrooptically active molecules, wherein the electrooptical properties of the material are modified at selected locations of the media in correspondance of the information to be recorded, whereby such recorded information can be read by detecting variations in the electrooptical properties of the polymer material across at least one dimension of the media.

2. The method of claim 1, wherein the media comprises a film or layer of such polymer material and the electrooptical properties of such film or layer are modified in a direction transverse to the surface of said film or layer.

3. The method of claim 1 or 2, wherein the information is recorded by acting on the orientation of the electrooptically active molecules of the polymer material at the selected locations of the media.

4. The method of claim 3, wherein said steps of acting on the orientation of the electrooptically active molecules comprises :

a) raising the temperature of the polymer material in at least one location of the media above a transitional level beyond which the orientation of these molecules within the polymer material can be altered by the action of an electric field;

b) applying a writing electric field in the media at aid location ; and

c) during said application step lowering the temperature of the polymer material at such location to a point below said transitional level so as to fix the orientation of the electrooptically active molecules resulting from the application of the electric field.

5. The method of claim 3 or 4, wherein all the electrooptically active molecules of said polymer material are initially randomly oriented throughout the media and said recording step includes orienting these molecules in a preferred direction at the selected locations of the media by applying an electric field while the temperature of the polymer material is returned below the transitional level.

6. The method of claim 3, wherein prior to the recording step, the electrooptically active molecules of the polymer material are essentially oriented in the same direction throughout at least one region of the media and said recording step includes allowing the electrooptically active molecules of polymer material to return to a state of random orientation at selected locations in such region by selectively raising the temperature thereat above a transitional level whereat the orientation of the electrooptically active molecules within the polymer material can be altered by an electric field.

7. The method of claim 5, wherein the intensity of said writing electric field is varied over a selected range in correspondance with the information to be recorded.

8. The method of any of claims 5 to 7, wherein said orienting step comprises applying to said media an electric field in the region of the selected location thereof and locally heating the polymer at that selected location above the transitional temperature level.

9. The method of any of claims 5 to 8, wherein said orienting step includes raising the temperature of said media above the transitional level in the region of the selected location thereof and applying a local electric field at such selected location while the temperature is allowed to return below the transitional level.

10. The method of claim 9, wherein said local electric field is applied by depositing electric charges on the polymer material at the selected location.

11. The method of claim 1 or 2, wherein such information is recorded by modifying the chemical structure of said electrooptically active molecules of the polymer material to irreversibly modify their electrooptical properties at the selected locations.

12. The method of claim 11, wherein such modifying step is performed by subjecting the selected location to a radiation having a wave length selected to break the electrooptically active molecules.

13. The method of claim 11 or 12, wherein the electrooptically active molecules of the polymer material have been oriented and fixed prior to the recording step.

14. The method of claim 6 or 13, wherein the media comprises a film of such polymer material and the electrooptically active molecules of the polymer material are essentially oriented, prior to the recording step, in a direction which is not perpendicular to the film.

15. A method for reading/reproducing the information recorded on a media in accordance with the method of any of claims 1 to 14 comprising applying an electrical field across the polymer material, simultaneously passing light to such polymer material, and analysing the light resulting from interaction therewith to detect the information recorded.

16. The method of claim 15, wherein said electric field is modulated and said step of analysing comprises detecting a corresponding modulation in the resulting light at locations of the media which exhibit optical anisotropy.

17. The method of claim 16, wherein said modulation of the electrical field is an alternating amplitude modulation.

18. The method of any of claims 15 to 17, wherein the light passed to the polymer material is polarized and said step of analysing comprises detecting changes in the state of polarization of such light as a result of interaction with the polymer material.

65. The method of any of claims 15 to 17, wherein said step of analyzing comprises detecting the variations in the anisotropy of the polymer material by Perot-Fabry interferometry.

20. Apparatus for recording information on a recording media comprising a polymer material including electrooptically active molecules, in accordance with any of claims 1 to 14, comprising means for locally modifying the electrooptical properties of the polymer material at selected locations of said media and means for effecting relative displacement of said media and said modifying means in correspondence with information to be recorded.

21. The apparatus of claim 20, wherein said modifying means comprises means for focusing a radiation toward said recording media and wherein said relative displacement means comprise means for controlling the focusing means to focus radiation in selected locations of the polymer material at varying depths from the surface of the media.

22. The apparatus of claim 20 or 21 for recording a media comprising a film of such polymer material, wherein said modifying means comprises means for applying an electric field at the selected location which is not perpendicular to the film.

23. The apparatus of claim 32, wherein said modifying means includes a laser beam emitter.

24. The apparatus of any of claims 20 to 22, wherein said modifying means comprises means for focusing a beam of light onto a photoconductive material in the vicinity of the selected location.

25. Apparatus for reproducing in accordance with the method of any of claims 15 to 19 information recorded on a media comprising a polymer material including electrooptically active molecules, such information being recorded in the form of variations in the electrooptical properties of the polymer material across at least one dimension of such media, said apparatus comprising means for applying an electrical field in the polymer material and means for passing light to selected locations of said media in the region where the electrical field is applied, means for detecting and analyzing the light resulting from the interaction of the incident light and the polymer material at the selected location and means for effecting relative displacement of the media, on the one hand, and of the light passing and/or electrical field applying means, on the other hand.

26. The apparatus of claim 25 further comprising means for alternatingly modulating amplitude of the electric field of said field applying means and wherein said light analyzing means comprises a bandpass filter for passing signal resulting from light affected by the alternating field amplitude modulation.

27. The apparatus of any of claims 42 to 45 wherein said light passing means comprises a laser emitter and means for focusing a beam emitted by said laser onto the selected location of the media.

28. The apparatus of any of claims 25 to 27 for reading/reproducing information from a media which comprises a film of the polymer material, further wherein said light passing means comprise means for polarizing the light emitted by said laser and is arranged to transmit incident light at an incidence which is oblique with respect to the polymer film, and said analyzing means comprises means for analyzing changes in the angle of polarization of the resulting light with respect to the incident light.

29. A media for recording information, comprising a transparent polymer material including electrooptically active molecules, whereby the information is recorded as a modulation of the electrooptical properties of the polymer material across at least one dimension of such media.

30. The media of claim 29 wherein the polymer material comprises a matrix and the electrooptically active molecules of a dopant which are trapped in the bonds of such matrix.

31. The media of claim 29 or 30 comprising at least one film of the transparent polymer material and wherein the electrooptically active molecules of the unrecorded media are orientated in a preferential direction throughout the media which is not perpendicular to the film.

32. The media of any claims 29 to 31, wherein the information is recorded as a combination of zones of the media where the electrooptically active molecules have respective different orientations.

33. The media of claim 31, comprising a layer of photoconductive material on one side of said polymer film.

34. The media of claim 31, wherein said polymer film is photoconductive.

35. The media of claim 31, comprising a plurality of superposed polymer films, each polymer film having a film electrode arranged on either side thereof.

36. A portable object such as a portable card comprising a support and an element of a media according to any of claim 29 through 35 on at least one side of said support.

37. The portable object of claim 36 further comprising a reflective layer between the polymer film of the media and the support.

38. The portable object of claim 36 or 37 wherein the electrooptical activity of the molecules at selected locations of the media has been selectively and irreversibly destroyed by a recording operation.

39. A terminal for operating with a portable object in accordance with claim 36, 37 or 38, comprising means for detecting locations within the polymer film of such objects wherein the electrooptically molecules have been preoriented and information recording means for modifying the chemical structure of such electrooptically molecules in selected locations where they have been preoriented to irreversibly cancel the electrooptical activity of such molecules in said locations.

FIG.1

FIG.2

FIG.4

EP 0 352 194 A1

## FIG. 3a

## FIG. 3b

## FIG. 2 bis

$$\Phi = \frac{2\pi}{\lambda} n.e$$

# FIG. 5

# FIG. 6

## FIG.5bis

## FIG.6bis

## FIG.6ter

EP 0 352 194 A1

FIG.7

FIG.8

FIG.10

FIG.10bis

EP 0 352 194 A1

## FIG.11

## FIG.9

## FIG.12

FIG.13

_FIG.14_

_FIG.15_

_FIG.16_

_FIG.17_

FIG.18

FIG.19

FIG.20

FIG.21

# FIG. 22

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4731754 (OGDEN ET AL) <br> * abstract; claims 1-8, 11, 17; figure 3 * <br> * column 6, line 45 - column 8, line 60 * | 1-5, 8, 9, 15, 16, 18, 20, 21 24, 25, 27, 29 | G11B11/00 <br> G11B9/00 <br> G11B11/12 |
| A | | 22, 23, 28, 29 | |
| X | EP-A-271900 (CANON K.K.) <br> * abstract; figures 1-4, 8, 11, 17 * <br> * page 2, line 30 - page 3, line 27 * <br> * page 19, lines 3 - 33 * <br> * page 4, line 3 - page 5, line 37 * | 1-4, 6, 8, 9, 15, 16, 18, 20, 21 24, 25, 27, 29 | |
| A | | 5, 13, 14, 22, 23, 28, 31, 39 | **TECHNICAL FIELDS SEARCHED (Int. Cl.5 )** <br><br> G11B <br> G11C |
| X | PATENT ABSTRACTS OF JAPAN <br> vol. 7, no. 278 (P-242)(1423) 10 December 1983, <br> & JP-A-58 155544 (TOKYO SHIBAURA DENKI K.K.) 16 September 1983, <br> * the whole document * | 1-4, 6, 8, 9, 15, 16, 18, 25 <br><br> 29 | |
| A | | 36, 37 | |
| | -/-- | | |

The present search report has been drawn up for all claims

| Place of search | Date of completion of the search | Examiner |
|---|---|---|
| THE HAGUE | 31 OCTOBER 1989 | BENFIELD A.D. |

EPO FORM 1503 03.82 (P0401)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 10, no. 202 (P-477)(2258) 15 July 1986, & JP-A-61 045438 (SEIKO EPSON CORP.) 05 March 1986, * the whole document * | 1-5, 8, 9, 15, 16, 18, 20 | |
| A | | 21, 24, 25, 27, 29, 30 39 | |
| X | PATENT ABSTRACTS OF JAPAN vol. 10, no. 254 (P-492)(2310) 30 August 1986, & JP-A-61 080537 (TOSHIBA CORP.) 24 April 1986, * the whole document * | 1-5, 8-10, 15, 16, 18, 20 25, 29 | |
| A | | 33 | |
| A | PATENT ABSTRACTS OF JAPAN vol. 1, no. 20 (E-76)(794) 24 March 1977, & JP-A-51 119236 (MATSUSHITA DENKI SANGYO K.K.) 19 October 1976, * the whole document * | 1-5, 7-9, 29, 30 | |
| A | MATERIALS LETTERS vol. 3, no. 3, January 1985, AMSTERDAM NL pages 127 - 129; T.J.OGDEN et al.: "Ferroelectric polymer as an optical memory material." | | TECHNICAL FIELDS SEARCHED (Int. Cl.5) |
| A | IBM TECHNICAL DISCLOSURE BULLETIN. vol. 15, no. 3, August 1972, NEW YORK US page 736 J.T.JACOBS et al.: "Ferro-electric beam-addressable file utilising thermo-electric writing and electro-optic readout" | | |
| A | DE-A-2005017 (FLIER) | | |
| A | GB-A-384258 (ZADDACH) | | |

The present search report has been drawn up for all claims

| Place of search | Date of completion of the search | Examiner |
|---|---|---|
| THE HAGUE | 31 OCTOBER 1989 | BENFIELD A.D. |

EPO FORM 1503 03.82 (P0401)